(19) Europäisches Patentamt
European Patent Office
Office européen des brevets

(11) EP 4 317 225 B1

(12) # EUROPEAN PATENT SPECIFICATION

(45) Date of publication and mention of the grant of the patent:
**10.12.2025 Bulletin 2025/50**

(21) Application number: **22780540.5**

(22) Date of filing: **25.03.2022**

(51) International Patent Classification (IPC):
***C08F 220/22** (2006.01)* ***C08L 33/16** (2006.01)*
***G03F 7/027** (2006.01)*

(52) Cooperative Patent Classification (CPC):
(C-Sets available)
**C08F 220/24; G03F 7/004; G03F 7/0046; G03F 7/027** (Cont.)

(86) International application number:
**PCT/JP2022/014252**

(87) International publication number:
**WO 2022/210326 (06.10.2022 Gazette 2022/40)**

(54) **FLUORINE RESIN, COMPOSITION, PHOTOCROSSLINKED PRODUCT, AND ELECTRONIC DEVICE PROVIDED THEREWITH**

FLUORHARZ, ZUSAMMENSETZUNG, LICHTVERNETZTES PRODUKT UND ELEKTRONISCHE VORRICHTUNG DAMIT

RÉSINE FLUORÉE, COMPOSITION, PRODUIT PHOTORÉTICULÉ ET DISPOSITIF ÉLECTRONIQUE ÉQUIPÉ DE CELLE-CI

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.03.2021 JP 2021056777**
**30.03.2021 JP 2021056778**

(43) Date of publication of application:
**07.02.2024 Bulletin 2024/06**

(73) Proprietor: **Tosoh Corporation**
**Yamaguchi 746-8501 (JP)**

(72) Inventors:
- **LEE, Junghwi**
  **Yokkaichi-shi, Mie 510-8540 (JP)**
- **FUKUDA, Takashi**
  **Yokkaichi-shi, Mie 510-8540 (JP)**
- **OKU, Shinya**
  **Yokkaichi-shi, Mie 510-8540 (JP)**

(74) Representative: **Novagraaf International SA**
**Chemin de l'Echo 3**
**1213 Onex, Geneva (CH)**

(56) References cited:
**WO-A1-2016/104317** **WO-A1-2016/114253**
**WO-A1-2016/114346** **WO-A1-2018/181364**
**WO-A1-2019/003682** **WO-A1-2019/003682**
**WO-A1-2022/071410** **JP-A- 2006 259 129**
**JP-A- 2008 050 440** **US-A- 4 529 783**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)

C-Sets
**C08F 220/24, C08F 220/302**

## Description

Technical Field

The present invention relates to a fluorine-based resin. More specifically, the present invention relates to a fluorine-based resin that can be suitably used in an electronic device.

Background Art

In recent years, there has been active development of technologies related to production of organic electronic devices by a full-printing method that is low-cost and highly productive. As an electronic device, development of an organic transistor is underway, for example. This organic transistor is produced through many steps including a step of protecting an organic transistor with a protective film made of a resin, and a step of forming a pattern of an EL-emission section. This pattern is provided, for example, to cover a source electrode, a drain electrode, and an organic semiconductor layer or a polymer layer. The pattern is not present on an electrode, where the EL-emission section is formed.

Normally, the EL-emission section is formed using photolithography which is a technique to form a pattern constituted by an exposed site and an unexposed site by exposing a substrate surface to which a photosensitive substance (resist) has been applied to light in a pattern via a photomask or a reticle. In photolithography, the EL-emission section is opened by a dry-etching method or by wet-etching.

As a pattern formation material, a photoreactive polymeric material has been used. In an application method such as a full-printing method, after the material is dissolved in a solvent and applied in the form of an ink, and the solvent is removed by drying, a pattern is formed by insolubilizing the material in a solvent by subjecting the material to a photocrosslinking reaction. Therefore, the polymeric material used in the application method such as the full-printing method is demanded to have both the properties, that is, the material has excellent solubility in a solvent, and, after the solvent is removed, a photocrosslinking reaction of the material can be carried out at normal temperature and in a short exposure time.

Here, the following description will discuss a method for producing an organic electroluminescent device included in an organic electroluminescent display, an organic electroluminescent illumination device. First, on a substrate, a portion where a pattern is to be formed by applying the above polymeric material is subjected to a photocrosslinking reaction, and a portion that has not been subjected to the photocrosslinking reaction is removed. Thus, the residual portion becomes a pattern. Various functional layers are stacked in the portion (inside of the pattern) where the polymeric material has been removed. A promising technique for forming the functional layer is to use an ink-like raw material. However, from the viewpoint of ink attachment to the inside of the pattern and prevention of ink leakage to the outside region beyond the portion where the polymeric material has not been removed (outside of the pattern), it is expected that the material constituting the pattern has liquid-repellency.

Moreover, in an organic semiconductor element, it is expected that, when forming an interlayer insulating film or a gate insulating film on a source electrode, a drain electrode, and an organic semiconductor layer, a pattern is formed by photolithography without damage, and a contact hole is formed in the insulating film.

Examples of such a material include a negative photosensitive resin composition that is highly photoreactive and capable of being used in patterning, and that can form a coating film having excellent dielectric characteristics, and a photocured pattern produced from such a negative photosensitive resin composition, which are disclosed in Patent Literature 1. However, for the resin, it is necessary to use water or an organic solvent during developing. Moreover, as a solvent in the composition, it is necessary to use an organic solvent such as propylene glycol monomethyl ether acetate (PGMEA). Both an organic solvent and water cause a decrease in performance of an electronic device. Under the circumstances, it has been demanded to develop a material that can adopt a fluorine-based solvent as a solvent in order to prevent a decrease in performance of an electronic device.

Examples of such a technique include a method of forming a pattern using a fluorine-based resin that is soluble in a fluorine-based solvent, as disclosed in Patent Literature 2 and Non-Patent Literature 1. However, there is a problem that the fluorine-based resin is not photocrosslinkable.

Examples of a fluorine-based resin that is soluble in a fluorine-based solvent and is photocrosslinkable include a fluorine-based resin disclosed in Non-Patent Literature 2 in which an anthracene crosslinking group is used.

WO2019/003682A1 discloses copolymers of cinnamoyl containing monomers for use in photo-aligned films, optical laminates and image display devices, US4529783A1 discloses fluorine-containing copolymer, photosensitive material containing the copolymer and dry offset printing plate using the material as a photosensitive layer.

Citation List

[Patent Literature]

[Patent Literature 1]
Japanese Patent Application Publication, Tokukai, No. 2017-167513
[Patent Literature 2]
Japanese Patent No. 6281427

[Non-patent Literature]

[Non-patent Literature 1]
Appl. Phys. Express 7, 101602 (2014)
[Non-patent Literature 2]
J Polym Sci A Polym Chem 53, 1252 (2015)

Summary of Invention

Technical Problem

However, the fluorine-based resin disclosed in Non-Patent Literature 2 is less photocrosslinkable and requires high light exposure intensity. Therefore, a fluorine-based resin with high photoreactivity is demanded.
The present invention is accomplished in view of the above problems, and its object is to provide a fluorine-based resin that has liquid-repellency, that is highly soluble in a fluorine-based solvent, and that can become insoluble in the solvent by being photocrosslinked at low light exposure intensity.

Solution to Problem

As a result of diligent studies for solving the above problems, the inventors of the present invention have found that a fluorine-based resin having a specific structure solves the above problems, and have accomplished the present invention, as defined in the appending claims.
That is, the present invention is a fluorine-based resin including: a repeating unit that is represented by Formula (1) below including a photocrosslinkable group; and a repeating unit that includes a fluorine atom.
That is, the present invention includes the following features.

<1> A fluorine-based resin including: a repeating unit that is represented by Formula (1) below including a photocrosslinkable group; and a repeating unit that includes a fluorine atom,

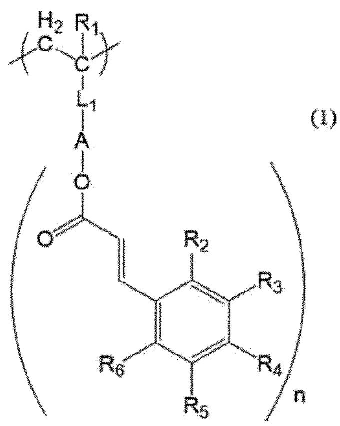

(1)

where $R_1$ represents a hydrogen atom or a methyl group, $L_1$ represents a single bond or a bivalent linking group, A represents a linking group having a valence of m, $R_2$, $R_3$, $R_4$, $R_5$, and $R_6$, which are identical to each other or different from each other, each represent one selected from the group consisting of a hydrogen atom, a halogen atom, linear

alkyl groups having 1 to 20 carbon atoms, branched alkyl groups having 3 to 20 carbon atoms, cyclic alkyl groups having 3 to 20 carbon atoms, linear alkyl halide groups having 1 to 20 carbon atoms, alkoxy groups having 1 to 20 carbon atoms, aryl groups having 6 to 20 carbon atoms, aryloxy groups having 6 to 20 carbon atoms, a cyano group, and an amino group, m represents an integer of 3 or more, and n represents an integer of m-1.

<2> The fluorine-based resin according to <1>, further including a repeating unit represented by Formula (2) below,

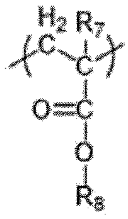 (2)

where $R_7$ represents a hydrogen atom or a methyl group, and $R_8$ represents an alkyl group having 1 to 30 carbon atoms.

<3> The fluorine-based resin according to <1> or <2>, in which: the repeating unit including the above fluorine atom is a repeating unit represented by Formula (3) below,

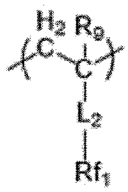 (3)

where $R_9$ represents a hydrogen atom or a methyl group, $L_2$ represents a single bond or a bivalent linking group, and $Rf_1$ represents one selected from the group consisting of linear fluoroalkyl groups having 1 to 15 carbon atoms, branched fluoroalkyl groups having 3 to 15 carbon atoms, and cyclic fluoroalkyl groups having 3 to 15 carbon atoms.

<4> The fluorine-based resin according to any one of <1> through <3>, in which: in the above Formula (1), A is one linking group selected from the group consisting of Formulae (a-1) through (a-4) below,

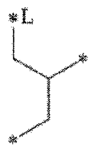
(a-1)

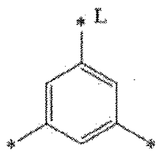
(a-2)

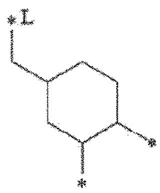
(a-3)

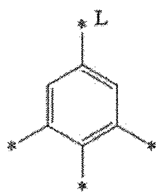
(a-4)

in Formulae (a-1) through (a-4), *L represents a linkage position with $L_1$ in the above Formula (1), and * at an end of a carbon atom represents a linkage position with an oxygen atom constituting an ester group in the above Formula (1).

<5> The fluorine-based resin according to <4>, in which: in the above Formula (1), A is a linking group represented by the above Formula (a-1).

<6> The fluorine-based resin according to any one of <1> through <5>, which is soluble in a fluorine-based solvent.

<7> A composition, including: a fluorine-based resin according to any one of <1> through <6>; and at least one of an organic solvent and a fluorine-based solvent.

<8> A photocrosslinked product, which is obtained from a fluorine-based resin according to any one of <1> through <6> or from a composition according to <7>.

<9> A pattern, which is constituted by a photocrosslinked product according to <8>.

<10> An electronic device, including a photocrosslinked product according to <8>.

Advantageous Effects of Invention

According to an aspect of the present invention, it is possible to obtain a fluorine-based resin that has liquid-repellency, that is highly soluble in a fluorine-based solvent, and that becomes insoluble in the solvent by being photocrosslinked at low light exposure intensity. The fluorine-based resin can be used in pattern formation. By carrying out pattern formation using the fluorine-based resin, it is possible to prevent a decrease in performance of an obtained electronic device.

Brief Description of Drawings

Fig. 1 is a diagram illustrating a cross-sectional shape of an organic transistor.
Fig. 2 is a diagram illustrating a cross-sectional shape of an organic transistor which is an aspect of an electronic device of the present invention.
Fig. 3 is a diagram showing a $^1$H-NMR chart of a fluorine-based resin 1 produced in Example 1.

Description of Embodiments

The following description will discuss details of a fluorine-based resin which is an aspect of the present invention.
The fluorine-based resin of the present invention is a fluorine-based resin including (i) a repeating unit that is represented by Formula (1) below and (ii) a repeating unit that includes a fluorine atom.

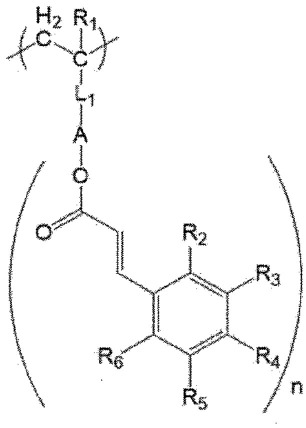

(1)

The above Formula (1) in the fluorine-based resin of the present invention includes a photocrosslinkable group. This makes it possible that the fluorine-based resin exhibits high photoreactivity, and that only a site irradiated with light in a film obtained by applying the resin is selectively insolubilized.
In Formula (1), $R_1$ represents a hydrogen atom or a methyl group.
In Formula (1), $L_1$ represents a single bond or a bivalent linking group.
The bivalent linking group at $L_1$ is preferably a bivalent linking group obtained by combining at least two groups selected from the group consisting of linear alkylene groups having 1 to 10 carbon atoms, branched alkylene groups having 3 to 10 carbon atoms, or cyclic alkylene groups having 3 to 10 carbon atoms, arylene groups having 6 to 12 carbon atoms, an ether group (-O-), a carbonyl group (-C(=O)-), and an imino group (-NH-). This makes it possible to form a flat and non-cracked film.
Specific examples of the linear alkylene group having 1 to 10 carbon atoms include a methylene group, an ethylene group, a propylene group, a butylene group, a pentylene group, a hexylene group, a decylene group.
Specific examples of the branched alkylene group having 3 to 10 carbon atoms include a dimethylmethylene group, a methylethylene group, a 2,2-dimethylpropylene group, a 2-ethyl-2-thylpropylene group.
Specific examples of the cyclic alkylene group having 3 to 10 carbon atoms include a cyclopropylene group, a cyclobutylene group, a cyclopentylene group, a cyclohexylene group, a cyclooctylene group, a cyclodecylene group, an adamantane-diyl group, a norbornane-diyl group, an exo-tetrahydrodicyclopentadiene-diyl group, and the like. Among these, the cyclohexylene group is preferable.
Specific examples of the arylene group having 6 to 12 carbon atoms include a phenylene group, a xylylene group, a biphenylene group, a naphthylene group, a 2,2'-methylenebisphenyl group. Among these, the phenylene group is preferable.
Among the above examples, the bivalent linking group is more preferably an ester bond (-C(=O)O-) obtained by combining a carbonyl group and an ether group, or a linking group obtained by combining a phenylene group and an ether

group, and is further preferably (-C(=O)O-).

In Formula (1), A represents a linking group having a valence of m.

m represents an integer of 3 or more, and is preferably an integer of 3 to 5, more preferably an integer of 3 to 4, and further preferably 3.

In order to achieve better solubility of the obtained resin in an organic solvent and in a fluorine-based solvent, A may be a hydrocarbon group that has a valence of m, has 1 to 24 carbon atoms, and may contain a substituent.

Examples of the substituent which the hydrocarbon group A having a valence of m may have include an alkyl group, an alkoxy group, a halogen atom, a hydroxyl.

For example, the alkyl group is preferably a linear, branched, or cyclic alkyl group having 1 to 18 carbon atoms, more preferably an alkyl group having 1 to 8 carbon atoms (e.g., a methyl group, an ethyl group, a propyl group, an isopropyl group, an n-butyl group, an isobutyl group, a sec-butyl group, a t-butyl group, a cyclohexyl group, or the like), further preferably an alkyl group having 1 to 4 carbon atoms, and particularly preferably a methyl group or an ethyl group.

Examples of the alkoxy group include alkoxy groups having 1 to 16 carbon atoms and having a linear or branched alkyl group, such as a methoxy group, an ethoxy group, an n-propoxy group, an n-butoxy group, an isobutoxy group, an n-pentyloxy group, an n-hexylixy group, an isohexyloxy group, an n-heptyloxy group, an n-octyloxy group, an n-nonyloxy group, an n-decyloxy group, an n-dodecyloxy group, an n-tetradecyloxy group, a 2-ethylhexyloxy group, a 3-ethylheptyloxy group, and a 2-hexyldecyloxy group, and is particularly preferably a group selected from the group consisting of a methoxy group, an ethoxy group, an n-propoxy group, an n-butoxy group, an isobutoxy group, an n-pentyloxy group, an n-hexyloxy group, an isohexyloxy group, an n-heptyloxy group, and an n-octyloxy group.

Examples of the halogen atom include a fluorine atom, a chlorine atom, a bromine atom, an iodine atom. Among these, the fluorine atom and the chlorine atom are preferable.

Among these, the hydrocarbon group A having a valence of m is preferably one linking group selected from the group consisting of Formulae (a-1) through (a-4) below.

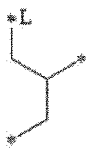
(a-1)

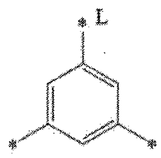
(a-2)

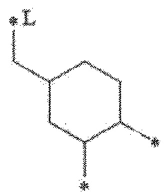
(a-3)

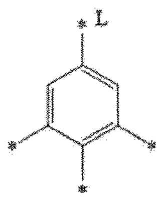
(a-4)

In Formulae (a-1) through (a-4), *L represents a linkage position with $L_1$ in the above Formula (1), and * at an end of a carbon atom represents a linkage position with an oxygen atom constituting an ester group in the above Formula (1).

For the reason of ease of reaction in monomer synthesis, the hydrocarbon group A having a valence of m is preferably one trivalent linking group selected from the group consisting of Formulae (a-1), (a-2), and (a-3), more preferably a trivalent linking group of Formula (a-1) or (a-2), and further preferably a trivalent linking group of Formula (a-1).

In Formula (1), $R_2$, $R_3$, $R_4$, $R_5$, and $R_6$, which are identical to each other or different from each other, each represent one selected from the group consisting of a hydrogen atom, a halogen atom, linear alkyl groups having 1 to 20 carbon atoms, branched alkyl groups having 3 to 20 carbon atoms, cyclic alkyl groups having 3 to 20 carbon atoms, linear alkyl halide groups having 1 to 20 carbon atoms, alkoxy groups having 1 to 20 carbon atoms, aryl groups having 6 to 20 carbon atoms, aryloxy groups having 6 to 20 carbon atoms, a cyano group, and an amino group.

Examples of the halogen atom include a fluorine atom, a chlorine atom, a bromine atom, an iodine atom. Among these, the fluorine atom and the chlorine atom are preferable.

The linear alkyl group having 1 to 20 carbon atoms is preferably an alkyl group having 1 to 6 carbon atoms, and specific examples thereof include a methyl group, an ethyl group, an n-propyl group. Among these, the methyl group or the ethyl group is preferable.

The branched alkyl group having 3 to 20 carbon atoms is preferably an alkyl group having 3 to 6 carbon atoms, and specific examples thereof include an isopropyl group, a tert-butyl group.

The cyclic alkyl group having 3 to 20 carbon atoms is preferably an alkyl group having 3 to 6 carbon atoms, and specific examples thereof include a cyclopropyl group, a cyclopentyl group, a cyclohexyl group. Among these, the cyclohexyl group is preferable.

The linear alkyl halide group having 1 to 20 carbon atoms is preferably a fluoroalkyl group having 1 to 4 carbon atoms, and specific examples thereof include a trifluoromethyl group, a perfluoroethyl group, a perfluoropropyl group, a perfluorobutyl group. Among these, the trifluoromethyl group is preferable.

The alkoxy group having 1 to 20 carbon atoms is preferably an alkoxy group having 1 to 8 carbon atoms, and specific examples thereof include a methoxy group, an ethoxy group, an n-butoxy group, a methoxyethoxy group.

The aryl group having 6 to 20 carbon atoms is preferably an aryl group having 6 to 12 carbon atoms, and specific examples thereof include a phenyl group, an α-methylphenyl group, a naphthyl group. Among these, the phenyl group is preferable.

The aryloxy group having 6 to 20 carbon atoms is preferably an aryloxy group having 6 to 12 carbon atoms, and specific examples thereof include a phenyloxy group, a 2-naphthyloxy group. Among these, the phenyloxy group is preferable.

Examples of the amino group include a primary amino group ($-NH_2$); a secondary amino group such as a methylamino group; and a tertiary amino group such as a dimethylamino group, a diethylamino group, a dibenzylamino group, and a group having an atomic bonding which is a nitrogen atom of a nitrogen-containing heterocyclic compound (e.g., pyrrolidine, piperidine, piperazine, and the like).

In order to enhance solubility in a fluorine-based solvent, photocurability, and liquid-repellency of the fluorine-based resin, $R_2$, $R_3$, $R_4$, $R_5$, and $R_6$ are each preferably a hydrogen atom, an alkyl group, a halogen atom, a linear alkyl halide group having 1 to 20 carbon atoms, and further preferably a hydrogen atom.

Specific examples of the repeating unit (hereafter sometimes referred to as a repeating unit B) represented by Formula (1) including a photocrosslinkable group include repeating units B-1 through B-26 indicated below. Among these, B-1 through B-16 are preferable, and B-1, B-2, B-13, and B-16 are particularly preferable. Note that, in the following Formulae, Me represents a methyl group, Et represents an ethyl group, and Pr represents an isopropyl group.

(B-1) (B-2) (B-3)

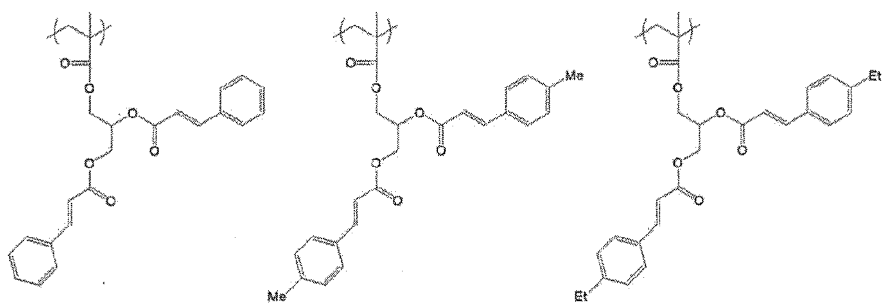

(B-4) (B-5) (B-6)

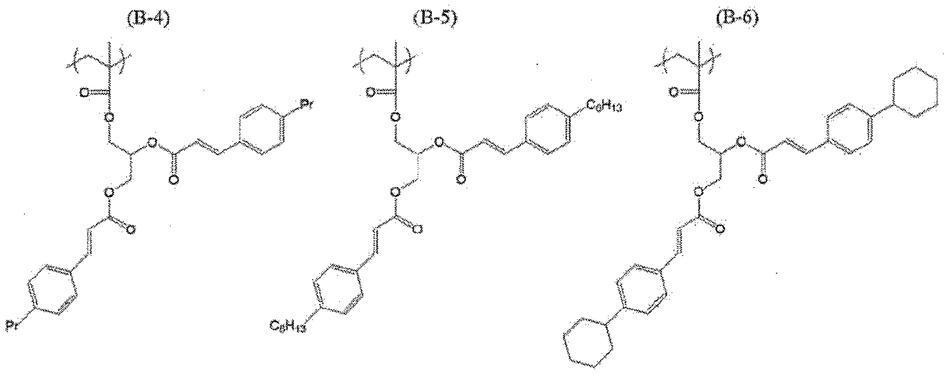

(B-7) (B-8) (B-9)

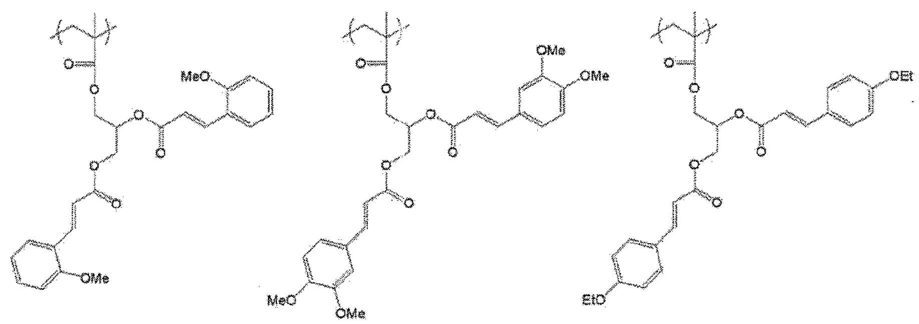

(B-10) (B-11) (B-12)

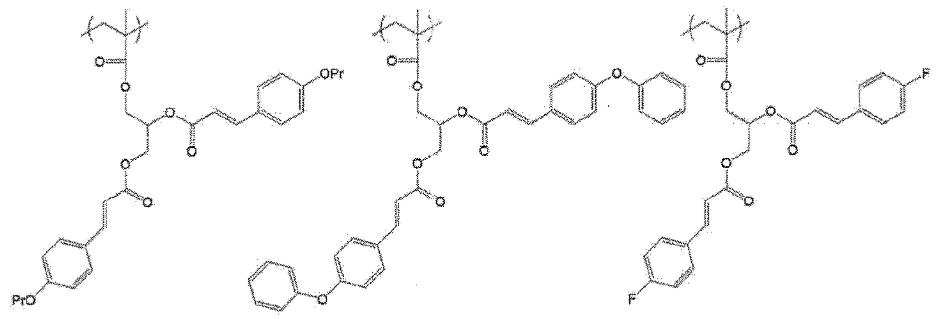

(B-13) (B-14) (B-15)

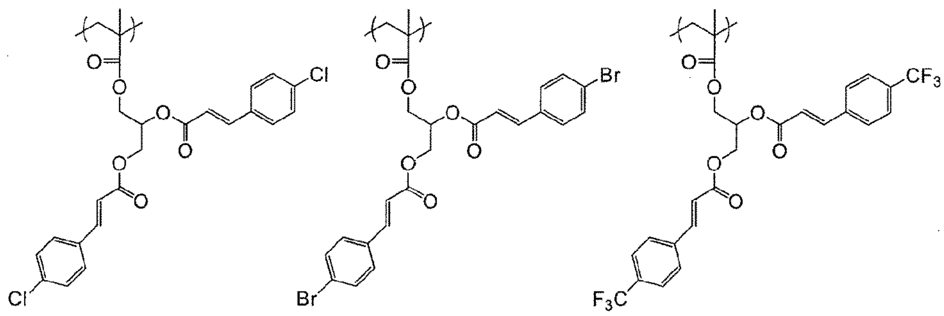

(B-16)

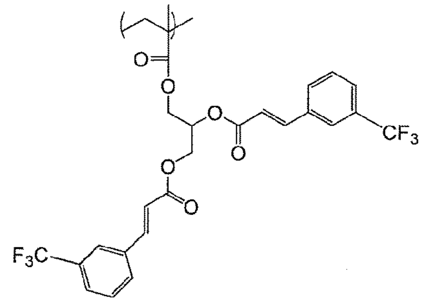

(B-17) (B-18) (B-19)

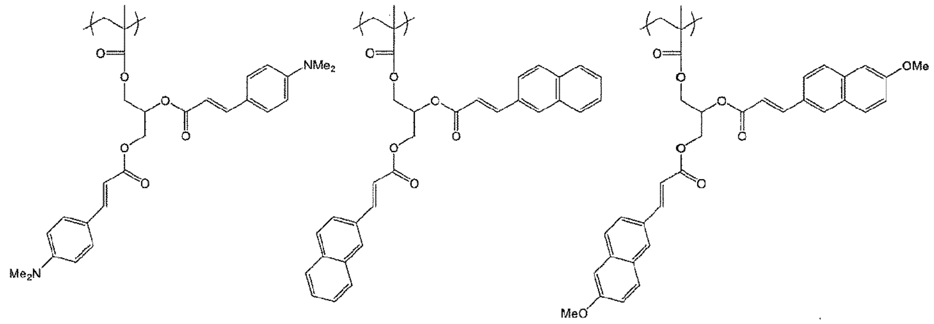

(B-20)

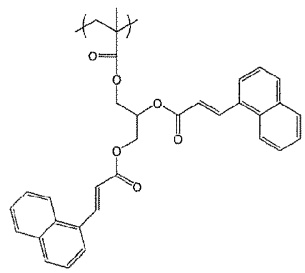

(B-21)

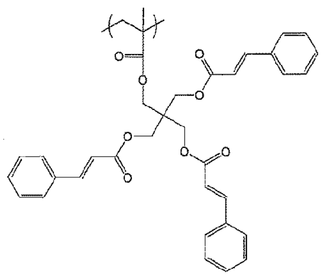

(B-22)

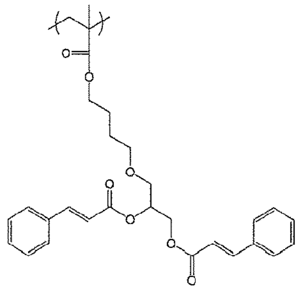

(B-23)

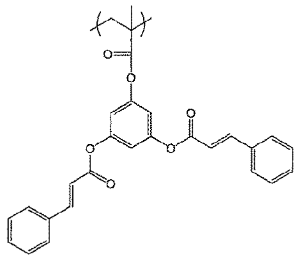

(B-24)

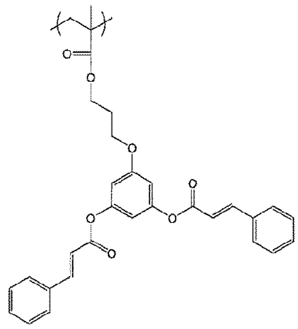

(B-25)

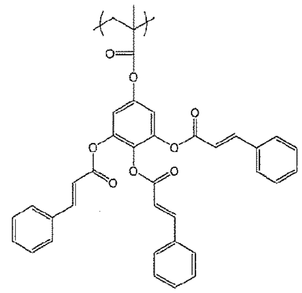

(B-26)

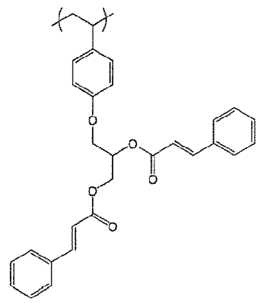

The fluorine-based resin of the present invention contains a repeating unit that includes a fluorine atom. This allows the fluorine-based resin to exhibit liquid-repellency, and to have high solubility in a fluorine-based solvent.

The repeating unit including a fluorine atom is preferably a repeating unit represented by Formula (3) below.

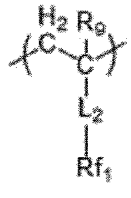

(3)

In Formula (3), $R_9$ represents a hydrogen atom or a methyl group.

In Formula (3), $L_2$ represents a single bond or a bivalent linking group.

The bivalent linking group in $L_2$ is preferably a bivalent linking group obtained by combining at least two groups selected from the group consisting of linear alkylene groups having 1 to 10 carbon atoms, branched alkylene groups having 3 to 20 carbon atoms, or cyclic alkylene groups having 3 to 20 carbon atoms, arylene groups having 6 to 12 carbon atoms, an ether group (-O-), a carbonyl group (-C(=O)-), and an imino group (-NH-). This makes it possible to form a flat and non-cracked film.

Specific examples of the linear alkylene group having 1 to 10 carbon atoms include a methylene group, an ethylene group, a propylene group, a butylene group, a pentylene group, a hexylene group, a decylene group.

Specific examples of the branched alkylene group having 3 to 10 carbon atoms include a dimethylmethylene group, a methylethylene group, a 2,2-dimethylpropylene group, a 2-ethyl-2-thylpropylene group.

Specific examples of the cyclic alkylene group having 3 to 10 carbon atoms include a cyclopropylene group, a cyclobutylene group, a cyclopentylene group, a cyclohexylene group, a cyclooctylene group, a cyclodecylene group, an adamantane-diyl group, a norbornane-diyl group, an exo-tetrahydrodicyclopentadiene-diyl group. Among these, the cyclohexylene group is preferable.
Specific examples of the arylene group having 6 to 12 carbon atoms include a phenylene group, a xylylene group, a biphenylene group, a naphthylene group, a 2,2'-methylenebisphenyl group. Among these, the phenylene group is preferable.
Among the above examples, the bivalent linking group is more preferably an ester bond (-C(=O)O-) obtained by combining a carbonyl group and an ether group, or a linking group obtained by combining a phenylene group and an ether group, and is further preferably (-C(=O)O-).
In Formula (3), $Rf_1$ represents one selected from the group consisting of linear fluoroalkyl groups having 1 to 15 carbon atoms, branched fluoroalkyl groups having 3 to 15 carbon atoms, and cyclic fluoroalkyl groups having 3 to 15 carbon atoms.
In a case where $Rf_1$ is a fluoroalkyl group, the fluorine-based resin in accordance with an aspect of the present invention exhibits affinity with a fluorine-based solvent and liquid-repellency.
In a case where $Rf_1$ is a linear fluoroalkyl group, specific examples of $Rf_1$ include alkyl groups having 10 to 14 carbon atoms, a methyl group, an ethyl group, a propyl group, a butyl group, a pentyl group, a hexyl group, a heptyl group, an octyl group, and a nonyl group each of which is substituted by a fluorine atom. In a case where an element binding to $Rf_1$ in $L_2$ is oxygen, a position substituted by the fluorine atom in $Rf_1$ only needs to be on a carbon atom other than a carbon atom that is directly bound to oxygen in $L_2$.
In a case where $Rf_1$ is a linear fluoroalkyl group, $Rf_1$ is preferably a group represented by Formula (4) below.

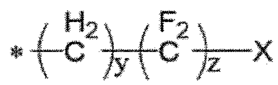 (4)

In Formula (4), * represents a linkage position with $L_2$ in Formula (4).
In Formula (4), X is a hydrogen atom or a fluorine atom.
In Formula (4), y is an integer of 1 to 4, and preferably 1 to 2.
In Formula (4), z is an integer of 1 to 14, preferably 2 to 10, and further preferably 4 to 8.
In a case where $Rf_1$ is a group represented by Formula (4), it becomes easier to synthesize a monomer that is used as a raw material for the repeating unit represented by Formula (3).
In a case where $Rf_1$ is a branched fluoroalkyl group, specific examples of $Rf_1$ include a 1,1,1,3,3,3-hexafluoroisopropyl group, a 1-(trifluoromethyl)-2,2,3,3,3-pentafluoropropyl group, a 1,1-bis(trifluoromethyl)-2,2,2-trifluoroethyl group, and a 1,1-bis(trifluoromethyl)ethyl group.
In a case where $Rf_1$ is a cyclic fluoroalkyl group, specific examples of $Rf_1$ include a 1,2,2,3,3,4,4,5,5-nonafluorocyclopentane group and a 1,2,2,3,3,4,4,5,5,6,6-undecafluorocyclohexane group.
The repeating unit represented by the above Formula (3) is preferably a repeating unit represented by Formula (5) below.

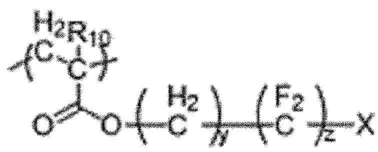 (5)

In Formula (5), $R_{10}$ represents either a hydrogen atom or a methyl group.
In Formula (5), X is a hydrogen atom or a fluorine atom.
In Formula (5), y is an integer of 1 to 4, and preferably 1 to 2.
In Formula (5), z is an integer of 1 to 14, preferably 2 to 10, and further preferably 4 to 8.
The fluorine-based resin in accordance with an aspect of the present invention may contain one repeating unit represented by the above Formula (3) and may contain two or more repeating units represented by Formula (3). For example, the fluorine-based resin may include both a repeating unit having, as $Rf_1$, a linear fluoroalkyl group described above and a repeating unit having, as $Rf_1$, a branched fluoroalkyl group described above. Alternatively, the fluorine-based resin may include two or more repeating units having linear fluoroalkyl groups differing in carbon number from each other. The fluorine-based resin in accordance with an aspect of the present invention preferably includes one repeating unit represented by Formula (3).
Specific examples of the repeating unit including a fluorine atom in the fluorine-based resin in accordance with an

aspect of the present invention include one selected from the group consisting of repeating units represented by Formulae (C-1) through (C-33) below.

(C-1) (C-2) (C-3) (C-4)

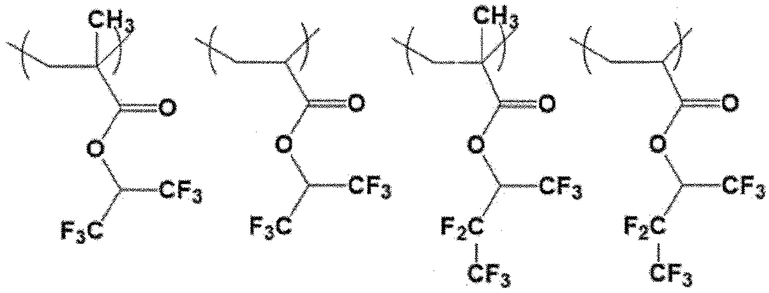

(C-5) (C-6) (C-7) (C-8)

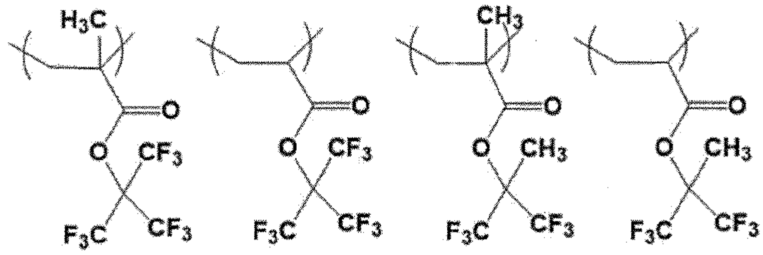

(C-9) (C-10) (C-11) (C-12)

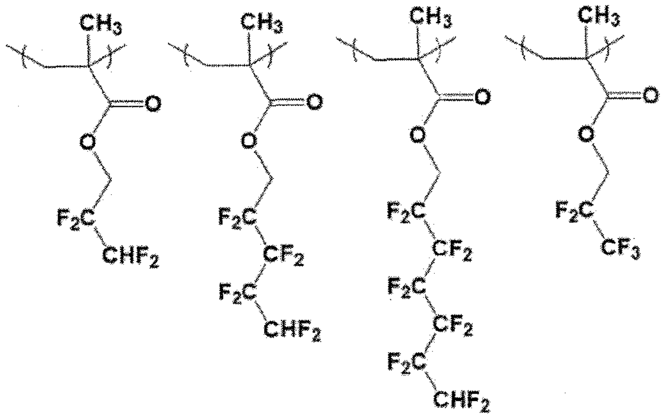

(C-13) (C-14) (C-15) (C-16)

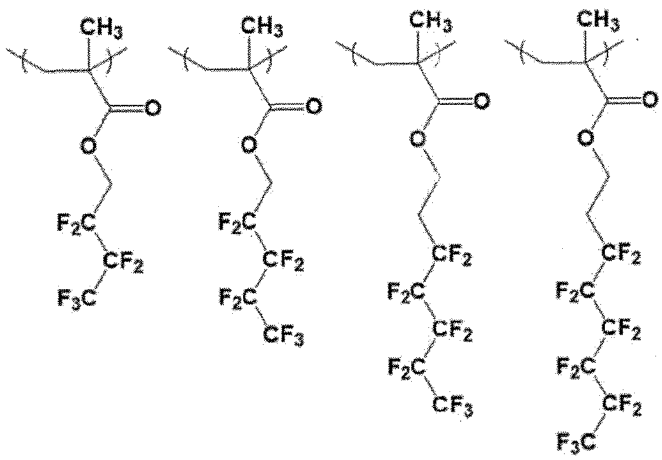

(C-17)
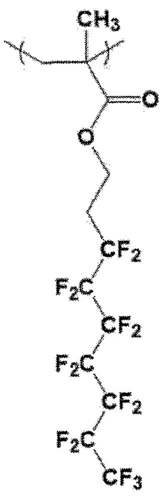

(C-18)
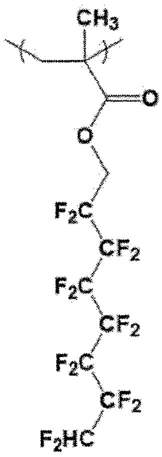

(C-19)
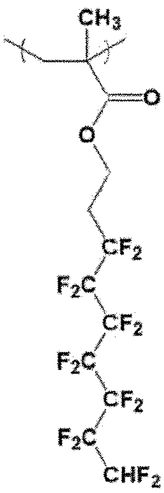

(C-20)
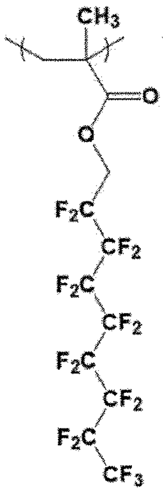

(C-21)
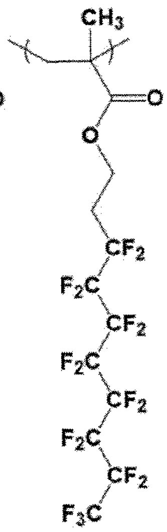

(C-22)
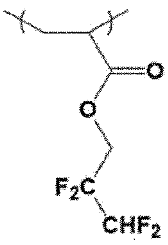

(C-23)
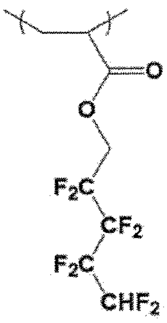

(C-24)
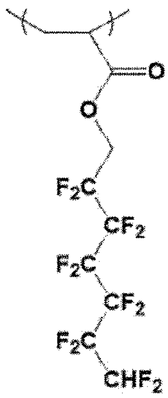

(C-25)
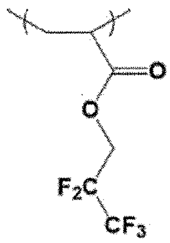

(C-26)
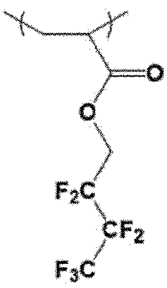

(C-27)
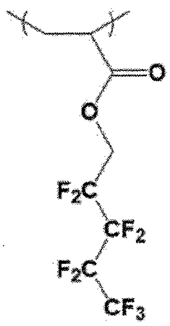

(C-28)
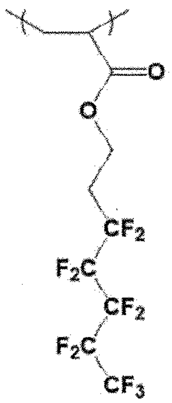

(C-29)
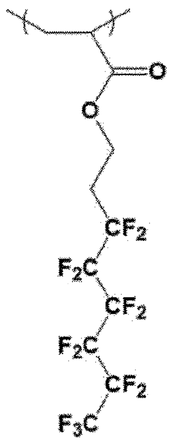

(C-30)

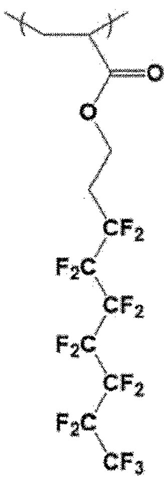

(C-31)

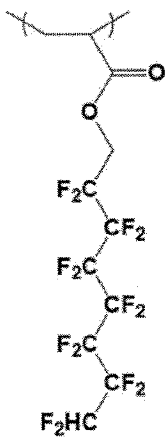

(C-32)

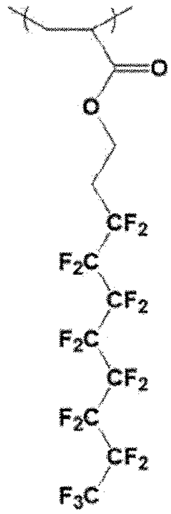

(C-33)

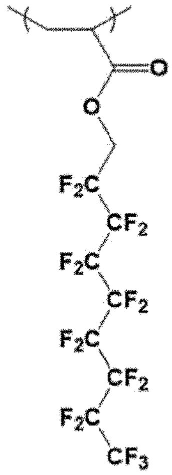

The repeating unit that includes a fluorine atom is preferably one selected from the group consisting of repeating units represented by the above Formulae (C-1) through (C-33), further preferably one selected from the group consisting of repeating units represented by Formulae (C-9) through (C-33), and particularly preferably one selected from the group consisting of repeating units represented by Formulae (C-14) through (C-21) or the group consisting of repeating units represented by Formulae (C-27) through (C-33).

The fluorine-based resin in accordance with an aspect of the present invention is preferably a copolymer containing the repeating unit represented by the above Formula (1) and the repeating unit represented by the above Formula (3). That is, the fluorine-based resin in accordance with an aspect of the present invention is preferably a copolymer represented by Formula (6) below.

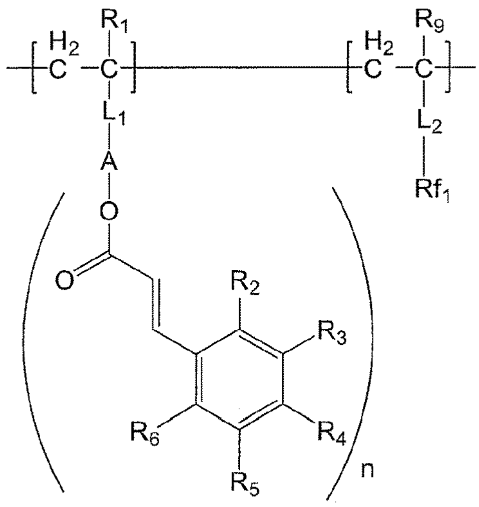

(6)

In Formula (6), $R_1$ and $R_9$ each represent a hydrogen atom or a methyl group, $L_1$ and $L_2$ each represent a single bond or a bivalent linking group, A represents a linking group having a valence of m, $R_2$, $R_3$, $R_4$, $R_5$, and $R_6$, which are identical to each other or different from each other, each represent one selected from the group consisting of a hydrogen atom, a halogen atom, linear alkyl groups having 1 to 20 carbon atoms, branched alkyl groups having 3 to 20 carbon atoms, cyclic alkyl groups having 3 to 20 carbon atoms, linear alkyl halide groups having 1 to 20 carbon atoms, alkoxy groups having 1 to 20 carbon atoms, aryl groups having 6 to 20 carbon atoms, aryloxy groups having 6 to 20 carbon atoms, a cyano group, and an amino group, m represents an integer of 3 or more, and n represents an integer of m-1. $Rf_1$ represents one selected from the group consisting of linear fluoroalkyl groups having 1 to 15 carbon atoms, branched fluoroalkyl groups having 3 to 15 carbon atoms, and cyclic fluoroalkyl groups having 3 to 15 carbon atoms.

In Formula (6), $R_1$, $L_1$, A, $R_2$, $R_3$, $R_4$, $R_5$, and $R_6$ are synonymous with $R_1$, $L_1$, A, $R_2$, $R_3$, $R_4$, $R_5$, and $R_6$ in the above Formula (1), respectively.

In Formula (6), $R_9$, $L_2$, and $Rf_1$ are synonymous with $R_9$, $L_2$, and $Rf_1$ in the above Formula (3), respectively.

The copolymer represented by Formula (6) may be either a random copolymer or a block copolymer.
From the viewpoint of enhancing solubility in a fluorine-based solvent and enhancing efficiency of photocuring, the fluorine-based resin in accordance with an aspect of the present invention contains the repeating unit represented by the above Formula (1) in an amount of preferably 10 mol% or more and 90 mol% or less, preferably 20 mol% or more and 80 mol% or less, and preferably 20 mol% or more and 70 mol% or less.
The fluorine-based resin in accordance with an aspect of the present invention contains the repeating unit that includes a fluorine atom in an amount of preferably 10 mol% or more and 90 mol% or less, preferably 20 mol% or more and 80 mol% or less, and preferably 30 mol% or more and 80 mol% or less.
The fluorine-based resin in accordance with an aspect of the present invention preferably further contains the repeating unit represented by Formula (2).

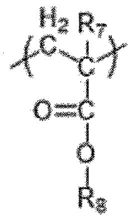
(2)

In Formula (2), $R_7$ represents a hydrogen atom or a methyl group.
In Formula (2), $R_8$ represents an alkyl group having 1 to 30 carbon atoms.
In Formula (2), $R_8$ represents an alkyl group having 1 to 30 carbon atoms. Examples of the alkyl having 1 to 30 carbon atoms include: linear alkyl groups such as a methyl group, an ethyl group, a propyl group, a butyl group, a pentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group, an icosyl group, a henicosyl group, and a docosyl group; branched alkyl groups such as an isopropyl group, an isobutyl group, an isovaleryl group, an isohexyl group, a 2-ethylhexyl group, a 3-ethylheptyl group, a 3-ethyldecyl group, a 2-hexyldecyl group, a 2-hexylundecyl group, a 2-octyldecyl group, a 2-octyldodecyl group, a 2-decyltetradecyl group, a 2-decylhexadecyl group, a 3-hexyldecyl group, a 3-octyldecyl group, a 3-octyldodecyl group, a 3-decyltetradecyl group, a 3-decylhexadecyl group, a 4-hexyldecyl group, a 4-octyldecyl group, a 4-octyldodecyl group, a 4-decyltetradecyl group, a 4-decylhexadecyl group, a 4-cyclohexylbutyl group, and an 8-cyclohexyloctyl group; and cyclic alkyl groups such as a cyclopentyl group, a cyclohexyl group, a cycloheptyl group, a 3-decylcyclopentyl group, and a 4-decylcyclohexyl group. Among these, one selected from the group consisting of a linear alkyl group having 1 to 15 carbon atoms and a branched alkyl group having 3 to 15 carbon atoms is preferable, a linear alkyl having 1 to 3 carbon atoms is more preferable, and the methyl group is more preferable.
Specific examples of the repeating unit represented by Formula (2) is one constituted by any of repeating units represented by methyl (meth)acrylate, ethyl (meth)acrylate, propyl (meth)acrylate, butyl (meth)acrylate, pentyl (meth) acrylate, hexyl (meth)acrylate, heptyl (meth)acrylate, octyl (meth)acrylate, and nonyl (meth)acrylate.
In a case where the fluorine-based resin in accordance with an aspect of the present invention has the repeating unit represented by Formula (2), from the viewpoint of enhancing solubility in a fluorine-based solvent and enhancing efficiency of photocuring, the fluorine-based resin in accordance with an aspect of the present invention contains the repeating unit represented by Formula (1) in an amount of preferably 10 mol% or more and 70 mol% or less, preferably 20 mol% or more and 50 mol% or less, and preferably 30 mol% or more and 50 mol% or less.
Moreover, the fluorine-based resin in accordance with an aspect of the present invention contains the repeating unit represented by Formula (2) in an amount of preferably 10 mol% or more and 70 mol% or less, preferably 20 mol% or more and 60 mol% or less, preferably 30 mol% or more and 50 mol% or less.
Moreover, the fluorine-based resin in accordance with an aspect of the present invention contains the repeating unit that includes a fluorine atom in an amount of preferably 10 mol% or more and 80 mol% or less, preferably 10 mol% or more and 60 mol% or less, preferably 10 mol% or more and 40 mol% or less, more preferably 10 mol% or more and 30 mol% or less.
The fluorine-based resin in accordance with an aspect of the present invention may include another monomer repeating unit within a range that does not deviate from the object of the present invention. Examples of the another monomer repeating unit include olefin residues such as an ethylene residue, a propylene residue, and a 1-butene residue; aromatic vinyl hydrocarbon residues such as a styrene residue, and an $\alpha$-methylstyrene residue; carboxylic acid vinyl ester residues such as a vinyl acetate residue, a vinyl propionate residue, and a vinyl pivalate residue; vinyl ether residues such as a methyl vinyl ether residue, an ethyl vinyl ether residue, and a butyl vinyl ether residue; N-substituted maleimide residues such as an N-methylmaleimide residue, an N-cyclohexylmaleimide residue, and an N-phenylmaleimide residue; an acrylonitrile residue; a methacrylonitrile residue; and the like.

In the fluorine-based resin of the present invention, a molecular weight thereof is not particularly limited, and can be, for example, 2,000 to 10,000,000 (g/mol). From the viewpoint of solution viscosity and mechanical strength of an obtained resin, the molecular weight is preferably 10,000 to 1,000,000 (g/mol).

The method for synthesizing the fluorine-based resin of the present invention is not particularly limited, and the fluorine-based resin can be synthesized by, for example, mixing a monomer forming the repeating unit B described above, a monomer forming the repeating unit including a fluorine atom described above, and a monomer forming any other repeating unit, and polymerizing a resultant mixture in an organic solvent using a radical polymerization initiator.

In a case where the fluorine-based resin in accordance with an aspect of the present invention contains the repeating unit represented by Formula (2), a method for synthesizing the fluorine-based resin is not particularly limited, and the fluorine-based resin can be synthesized by, for example, mixing a monomer forming the repeating unit B described above, a monomer forming the repeating unit represented by Formula (2) described above, a monomer forming the repeating unit including a fluorine atom described above, and a monomer forming any other repeating unit, and polymerizing a resultant mixture in an organic solvent using a radical polymerization initiator.

The following description will discuss a composition which is one aspect of the present invention.

The composition in accordance with an aspect of the present invention includes: at least one of an organic solvent and a fluorine-based solvent; and a fluorine-based resin.

The above fluorine-based solvent only needs to be one that dissolves the fluorine-based resin of the present invention. By using the fluorine-based solvent as a solvent to dissolve the fluorine-based resin, it is possible to minimize damage to device constituent members mainly constituted by organic matter during production of an electronic device by a full-printing method, and this allows the electronic device to sufficiently provide its performance.

In a fluorine-based compound constituting the fluorine-based solvent, a fluorine atom content is 50% by mass or more and 70% by mass or less, more preferably 55% by mass or more and 70% by mass or less, relative to a total mass of the fluorine-based compound. If the fluorine atom content exceeds 70% by mass, the fluorine-based resin is not dissolved sufficiently. If the fluorine atom content is less than 50% by mass, a surface of an organic semiconductor film may be dissolved or swollen when application or printing onto the organic semiconductor film is carried out.

As the fluorine-based solvent contained in the composition of the present invention, fluorine-containing hydrocarbon, fluorine-containing ether, or fluorine-containing alcohol indicated below can be preferably used, and the fluorine-containing hydrocarbon or the fluorine-containing ether can be more preferably used.

The fluorine-containing hydrocarbon has a low ozone depleting potential and is preferably used as the fluorine-based solvent contained in the composition of the present invention. In particular, fluorine-containing hydrocarbon which has 4 to 8 carbon atoms, which is linear, branched, or cyclic hydrocarbon, and in which at least one hydrogen atom is substituted by a fluorine atom, can be easily applied and is preferable.

Specific examples of such a fluorine-containing hydrocarbon include one in which at least one hydrogen atom in butane, pentane, hexane, heptane, octane, cyclopentane, cyclohexane, or benzene has been substituted by a fluorine atom. Specific examples of such a fluorine-containing hydrocarbon include 1,1,1,3,3-pentafluorobutane, 1,1,1,2,2,3,3,4,4,5,5,6,6-tridecafluorohexane, 2H,3H-decafluoropentane, 1,1,1,2,2,3,3,4,4,5,5,6,6-tridecafluorooctane, hexafluorocyclopentane, 1,1,2,2,3,3,4-heptafluorocyclopentane, and hexafluorobenzene.

The fluorine-containing hydrocarbon has a boiling point of preferably 200°C or less, and further preferably 180°C or less. In a case where the boiling point of the fluorine-containing hydrocarbon is not more than 200°C, it is easy to evaporate and remove the fluorine-containing hydrocarbon by heating.

Among the above fluorine-containing hydrocarbons, examples of fluorine-containing hydrocarbon having a particularly preferable boiling point are as follows.

Examples of such a fluorine-containing hydrocarbon include 2H,3H-decafluoropentane, 1,1,2,2,3,3,4-heptafluorocyclopentane, 1,1,2,2,3,3,4,4,5,5,6,6-tridecafluorooctane, 1,1,1,2,2,3,3,4,4,5,5,6,6-tridecafluorohexane, and hexafluorobenzene.

In view of low ozone depleting potential, fluorine-containing ether can be used as the fluorine-based solvent. In particular, the fluorine-containing ether has a boiling point of preferably 200°C or less, and further preferably 180°C or less. In a case where the boiling point of the fluorine-containing ether is not more than 200°C, it is easy to evaporate and remove the fluorine-containing ether from a fluorine-based resin film by heating.

Preferable examples of the fluorine-containing ether include 1,1,2,3,3,3-hexafluoro-1-(2,2,2-trifluoroethoxy) propane, 1,1,2,3,3,3-hexafluoro-1-(2,2,3,3,3-pentafluoropropoxy)propane, 1,1,2,3,3,3-hexafluoro-1-(2,2,3,3-tetrafluoropropoxy)propane, 2,2,3,3,3-pentafluoro-1-(1,1,2,2-tetrafluoroethoxy)propane, 1,1,1,2,2,3,3-heptafluoro-3-methoxypropane, methyl perfluorobutyl ether, and ethyl nonafluorobutyl ether.

Examples of a fluorine-containing ether having a preferable boiling point include ethyl nonafluorobutyl ether, methyl perfluorobutyl ether, ethyl nonafluorobutyl ether, 1,1,1,2,3,4,4,5,5,5-decafluoro-3-methoxy-2-(trifluoromethyl) pentane, 2-(trifluoromethyl)-3-ethoxydodecafluorohexane, (1,1,1,2,3,3-hexafluoropropoxy)pentane, 1,1,2,2-tetrafluoroethyl 2,2,2-trifluoroethylether, and methoxyperfluoroheptene.

As the fluorine-based solvent, fluorine-containing alcohol can be used. The fluorine-containing alcohol used has

a boiling point of preferably 200°C or less, and further preferably 180°C or less. In a case where the boiling point of the fluorine-containing alcohol is not more than 200°C, it is easy to evaporate and remove the fluorine-containing alcohol by heating.

Preferable examples of the fluorine-containing alcohol include 1H,1H-trifluoroethanol, 1H1H-pentafluoropropanol, 1H,1H-heptafluorobutanol, 2-(perfluorobutyl)ethanol, 3-(perfluorobutyl)propanol, 2-(perfluorohexyl)ethanol, 3-(perfluorohexyl)propanol, 1H,1H,3H-tetrafluoropropanol, 1H,1H,5H-octafluoropentanol, 1H,1H,7H-dodecafluoroheptanol, 2H-hexafluoro-2-propanol, and 1H,1H,3H-hexafluorobutanol.

The composition may contain two or more fluorine-based solvents in order to enhance solubility of the fluorine-based resin.

The organic solvent used in the composition of the present invention refers to an organic solvent which is not a fluorine-based solvent. The organic solvent is not particularly limited, provided that the fluorine-based resin of the present invention is dissolved in the organic solvent, and examples of the organic solvent include hexane, heptane, octane, decane, dodecane, tetradecane, hexadecane, decalin, indan, 1-methylnaphthalene, 2-ethylnaphthalene, 1,4-dimethylnaphthalene, a dimethylnaphthalene isomer mixture, toluene, xylene, ethylbenzene, 1,2,4-trimethylbenzene, mesitylene, isopropyl benzene, pentylbenzene, hexylbenzene, tetralin, octylbenzene, cyclohexylbenzene, 1,2-dichlorobenzene, 1,3-dichlorobenzene, 1,4-dichlorobenzene, trichlorobenzene, 1,2-dimethoxybenzene, 1,3-dimethoxybenzene, γ-butyrolactone, 1,3-butylene glycol, ethylene glycol, benzyl alcohol, glycerin, cyclohexanol acetate, 3-methoxy butyl acetate, ethylene glycol monomethyl ether acetate, ethylene glycol monobutyl ether acetate, propylene glycol monomethyl ether acetate, anisole, cyclohexanone, mesitylene, 3-methoxy butyl acetate, cyclohexanol acetate, dipropylene glycol diacetate, dipropylene glycol methyl ether acetate, diethylene glycol monobutyl ether acetate, diethylene glycol monoethyl ether acetate, 1,6-hexanediol diacetate, 1,3-butylene glycol diacetate, 1,4-butanediol diacetate, ethyl acetate, phenyl acetate, dipropylene glycol dimethyl ether, dipropylene glycol methyl-N-propyl ether, tetradecahydrophenanthrene, 1,2,3,4,5,6,7,8-octahydrophenanthrene, decahydro-2-naphthol, 1,2,3,4-tetrahydro-1-naphthol, α-terpineol, isophoronetriacetindecahydro-2-naphthol, dipropylene glycol dimethyl ether, 2,6-dimethylanisole, 1,2-dimethylanisole, 2,3-dimethylanisole, 3,4-dimethylanisole, 1-benzothiophene, 3-methylbenzothiophene, 1,2-dichloroethane, 1,1,2,2-tetrachloroethane, chloroform, dichloromethane, tetrahydrofuran, 1,2-dimethoxyethane, dioxane, cyclohexanone, acetone, methyl ethyl ketone, diethyl ketone, diisopropyl ketone, acetophenone, N,N-dimethylformamide, N-methyl-2-pyrolidone, limonene. In order to obtain a film having a preferable property, an organic solvent having high solvency to dissolve a fluorine-based resin is suitable. Such an organic solvent is preferably xylene or propylene glycol monomethyl ether acetate. It is possible to use a mixed solvent in which two or more of the above solvents are mixed at an appropriate ratio.

The composition containing the fluorine-based resin in accordance with an aspect of the present invention and at least one of an organic solvent and a fluorine-based solvent contains the fluorine-based resin in an amount of preferably 1 wt% or more and 50 wt% or less, and contains the solvent in an amount of preferably 50 wt% or more and 99 wt% or less.

The composition in accordance with an aspect of the present invention may contain a photosensitizer. The photosensitizer only needs to facilitate a crosslinking reaction of the photocrosslinkable group.

Examples of the photosensitizer include acyloins such as benzoin, benzoin methyl ether, benzoin isopropyl ether, and benzoin isobutyl ether; carbonyls such as anthraquinone, 2-methylanthraquinone, 1,2-benzanthraquinone, 1-chloroanthraquinone, and cyclohexanone; diketones such as diacetyl and benzyl; organic sulfides such as diphenyl monosulfide, diphenyl disulfide, and tetramethylthiuram disulfide; phenones such as acetophenone, benzophenone, 4,4'-bis(dimethylamino)benzophenone, 4,4'-bis(diethylamino)benzophenone, o-methoxybenzophenone, and 2,4,6-trimethoxybenzophenone; sulfonyl halides such as p-toluenesulfonyl chloride, I-naphthalenesulfonyl chloride, 1,3-benzenesulfonyl chloride, 2,4-dinitrobenzenesulfonyl bromide, and p-acetamidebenzenesulfonyl chloride; aromatic nitro compounds such as 5-nitrofluorene, 5-nitroacenaphthene, N-acetyl-4-nitro-1-naphthylamine, and picramide; coumarins such as 7-diethylamino-3-thenoylcoumarin and 3,3'-carbonylbis(7-diethylaminocoumarin); halogenated hydrocarbons such as carbon tetrachloride, hexabromoethane, and 1,1,2,2-tetrabromoethane; nitrogen derivatives such as diazomethane, abbisisobutyronitrile, hydrazine, and trimethylbenzylammonium chloride; pigments such as ethionine, thionin, and methylene blue. By adding the photosensitizer, it is possible to crosslink (insolubilize) the fluorine-based resin in accordance with an aspect of the present invention at lower light exposure intensity. It is possible to use two or more of the sensitizers in combination, if necessary.

The composition containing the fluorine-based resin in accordance with an aspect of the present invention, a photosensitizer, and at least one of an organic solvent and a fluorine-based solvent contains the fluorine-based resin in an amount of preferably 1 wt% or more and 50 wt% or less, and contains the solvent in an amount of preferably 50 wt% or more and 99 wt% or less, and contains the photosensitizer in an amount of preferably 0.001 wt% or more and 5 wt% or less.

The following description will discuss a pattern which is one aspect of the present invention.

The fluorine-based resin of the present invention can be used to form a pattern. More specifically, the fluorine-based resin of the present invention or a composition thereof is used to obtain a photocrosslinked product to form a pattern.

First, by a known film formation method, a coating film of the fluorine-based resin is formed on a surface of a substrate. Examples of the substrate include: various glass plates; polyesters such as polyethylene terephthalate;

polyolefins such as polypropylene and polyethylene; thermoplastic plastic sheets of polycarbonate, polymethyl methacrylate, polysulfone, and polyimide; epoxy resins; polyester resins; thermosetting plastic sheets of, for example, a poly(meth)acrylic resin.

Examples of a method for forming a coating film include spin coating, drop casting, dip coating, doctor blade coating, pad printing, squeegee coating, roller coating, rod bar coating, air knife coating, wire bar coating, flow coating, gravure printing, flexo printing, super flexo printing, screen printing, inkjet printing, letterpress reverse printing, reverse offset printing, adhesion contrast printing.

Next, the coating film is dried. By drying, the solvent is volatilized, and thus a non-adhesive coating film is obtained. Drying conditions vary depending on a boiling point and a mixing ratio of a solvent used. Preferably, the drying conditions can be wide ranges of approximately 50°C to 150°C and approximately 10 seconds to 2,000 seconds.

At the time of film formation, when a printing technique is used to form a coating film having a predetermined shape, i.e., a shape identical to an intended pattern, the coating film having the predetermined shape is photocrosslinked by light exposure to obtain a photocrosslinked product, and the photocrosslinked product is then fixed to form a pattern.

On the other hand, in a case where a coating film having a predetermined shape is not formed at the time of film formation, a pattern can be formed from the coating film using a photolithographic technique. In a case where the photolithographic technique is used, a dried coating film is first exposed to light via a mask having a predetermined shape, that is, a shape that can form an intended pattern, and the coating film is thus photocrosslinked.

In curing the fluorine-based resin of the present invention by photocrosslinking, radial rays such as ultraviolet rays or visible light are used. For example, ultraviolet rays having a wavelength of 245 nm to 435 nm are used. A radiation quantity may be changed as appropriate according to a composition of the resin, and can be, for example, 10 $mJ/cm^2$ to 5,000 $mJ/cm^2$. From the viewpoint of preventing a decrease in degree of crosslinking and enhancing economy by shortening a process time, the radiation quantity is preferably 100 $mJ/cm^2$ to 4,000 $mJ/cm^2$. Specific examples of a light irradiator or a light source include a sterilization lamp, an ultraviolet fluorescent light, a carbon arc, a xenon lamp, a high-pressure mercury lamp for copying, a medium-pressure or high-pressure mercury lamp, an ultra-high-pressure mercury lamp, an electrodeless lamp, a metal halide lamp.

Ultraviolet radiation is usually carried out in the atmosphere. However, ultraviolet radiation can also be carried out in an inert gas or under a predetermined rate of inert gas flow, if necessary. The above photosensitizer may be, if necessary, added to facilitate a photocrosslinking reaction. Then, developing is carried out with a developer, and an unexposed portion is removed. The developer is not particularly limited, provided that an uncured fluorine-based resin is dissolved in the developer. Examples of the developer include aromatic solvents such as benzene, toluene, and xylene; ether-based solvents such as dioxane, diethyl ether, tetrahydrofuran, and diethylene glycol dimethyl ether; ketone-based solvents such as acetone and methyl ethyl ketone; ester-based solvents such as ethyl acetate, butyl acetate, isopropyl acetate, and propylene glycol monomethyl ether acetate; fluorine-based solvents such as 2H,3H-decafluoropentane, 1,1,2,2,3,3,4-heptafluorocyclopentane, 1,1,2,2-tetrafluoroethyl-2,2,2-trifluoroethylether, hexafluorobenzene, 2,2,3,3-tetrafluoro-1-propanol, 2,2,3,3,4,4,5,5-octafluoro-1-pentanol, 1H,1H,7H-dodecafluoro-1-heptanol, and 2,2,3,3,4,4,4-heptafluoro-1-butanol.

The developing time is preferably 30 to 300 seconds. The developing method can be any one of a puddle method, a dipping method. After developing, cleaning is carried out with a solvent, and the solvent on the substrate is removed by air-dried with compressed air or compressed nitrogen. Subsequently, a pattern is formed by carrying out a heat treatment for 5 to 90 minutes with a heating device such as a hot plate or an oven, preferably at 40°C to 150°C.

After undergoing the above photolithography process to form a pixel pattern, dirt on the substrate surface in pixels may be removed. For example, it is possible to clean the substrate surface by short-wavelength ultraviolet radiation such as a low-pressure mercury lamp or excimer UV, a photo-ashing treatment, or the like. The photo-ashing treatment is a treatment in which short-wavelength ultraviolet radiation is carried out in the presence of an ozone gas. The above short-wavelength ultraviolet ray is light having a main peak at a wavelength of 100 nm to 300 nm.

Thus, the fluorine-based resin of the present invention itself is soluble in a fluorine-based solvent or an organic solvent. When the fluorine-based resin is irradiated with light, the photocrosslinkable group present in the side chain is crosslinked and cured, and the fluorine-based resin becomes insoluble in the solvent used. Taking advantage of this property, the fluorine-based resin of the present invention can be used as a negative-type resist in which a part that has not been irradiated with light is removed by a fluorine-based solvent or an organic solvent when the fluorine-based resin is crosslinked by irradiation with light.

After patterning with use of the fluorine-based resin of the present invention, a portion (outside of the pattern) where the fluorine-based resin has been crosslinked and remains has a contact angle with respect to the ink at preferably 40° or more and more preferably 50° or more, in order to avoid spread of wetting of the ink for forming a functional layer.

The fluorine-based resin of the present invention can be formed into a protective film in a manner similar to patterning such as a coating film formation method, photocrosslinking, and developing.

The fluorine-based resin of the present invention has excellent liquid-repellency, and can be used as a patterning material in production of an organic transistor element, a color filter, and an organic EL element. The fluorine-based resin of

the present invention can be used in an electronic device including the above organic transistor element, the color filter, and the organic EL element.

The following description will discuss details of an electronic device which is an aspect of the present invention.

The fluorine-based resin of the present invention can be used in an electronic device. More specifically, the fluorine-based resin of the present invention can be used in an electronic device including a photocrosslinked product obtained from a composition containing the fluorine resin or the fluorine-based resin of the present invention and at least one of an organic solvent and a fluorine-based solvent. Examples of the electronic device include an organic transistor.

A general organic transistor is obtained by providing a gate insulating layer on a substrate, further forming an organic semiconductor layer on the gate insulating layer, and providing a source electrode, a drain electrode, and a gate electrode. An example of an element structure of the organic transistor is illustrated in Fig. 1 as a cross-sectional view. The reference numeral 1001 indicates an element structure of a bottom gate-top contact type. The reference numeral 1002 indicates an element structure of a bottom gate-bottom contact type. The reference numeral 1003 indicates an element structure of a top gate-top contact type. The reference numeral 1004 indicates an element structure of a top gate-bottom contact type. The reference numeral 1 indicates an organic semiconductor layer, the reference numeral 2 indicates a substrate, the reference numeral 3 indicates a gate electrode, the reference numeral 4 indicates a gate insulating layer, the reference numeral 5 indicates a source electrode, and the reference numeral 6 indicates a drain electrode.

An aspect of the organic transistor of the present invention is illustrated in Fig. 2. An organic transistor 1005 illustrated in Fig. 2 corresponds to the bottom gate-bottom contact type in Fig. 1. The reference numeral 7 indicates a pattern, and the reference numeral 8 indicates a protective film layer.

In the organic transistor, the substrate that can be used is not particularly limited, provided that the substrate can ensure sufficient flatness to produce an element. Examples of the substrate include: inorganic material substrates such as glass, quartz, aluminum oxide, highly doped silicon, silicon oxide, tantalum dioxide, tantalum pentaoxide, and indium tin oxide; plastics; metals such as gold, copper, chromium, titanium, and aluminum; ceramics; coated paper; surface-coated nonwoven fabric. The substrate may be made of a composite material constituted by these materials or a multilayered material of these materials. It is also possible to coat surfaces of these materials to adjust the surface tension.

Examples of plastic used as the substrate include polyethylene terephthalate, polyethylene naphthalate, triacetylcellulose, polycarbonate, polymethyl acrylate, polymethyl methacrylate, polyvinyl chloride, polyethylene, an ethylene-vinyl acetate copolymer, polymethylpentene-1, polypropylene, cyclic polyolefin, fluorinated cyclic polyolefin, polystyrene, polyimide, polyvinyl phenol, polyvinyl alcohol, poly(diisopropylfumarate), poly(diethylfumarate), poly(diisopropylmaleate), polyether sulfone, polyphenylene sulfide, polyphenylene ether, a polyester elastomer, a polyurethane elastomer, a polyolefin elastomer, a polyamide elastomer, and a styrene block copolymer. It is possible to stack two or more kinds of the above plastics to be used as a substrate.

An organic semiconductor that can be used in the organic semiconductor layer is not particularly limited. Either an N-type organic semiconductor or a P-type organic semiconductor can be used. Alternatively, it is possible to use a bipolar transistor combining the N-type and the P-type. It is possible to use any of a low-molecular-weight organic semiconductor and a high-molecular-weight organic semiconductor, and it is possible to mix and use those organic semiconductors. Examples of specific compounds of the organic semiconductor include compounds represented by Formulae (D-1) through (D-11) below.

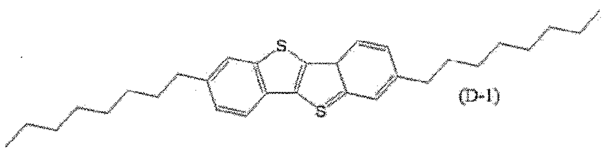
(D-1)

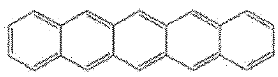
(D-2)

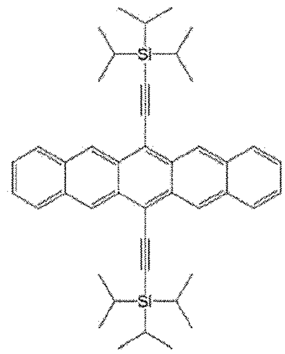

(D-3)

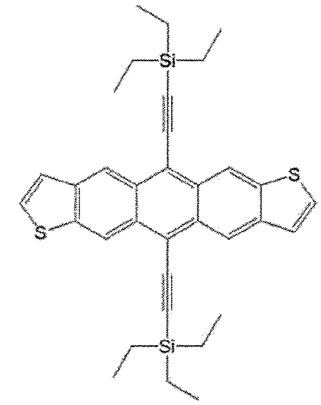

(D-4)

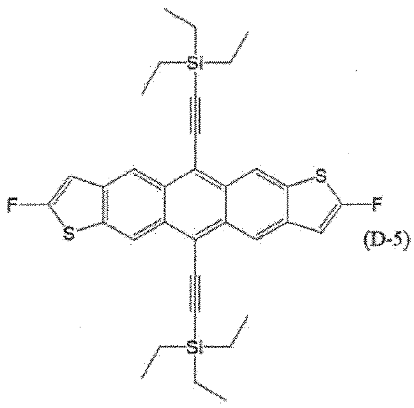

(D-5)

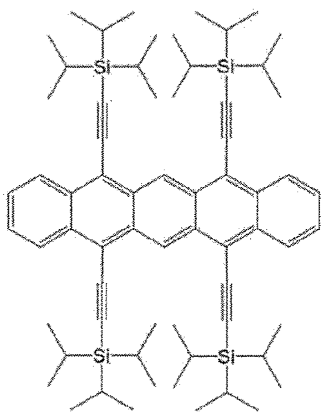

(D-6)

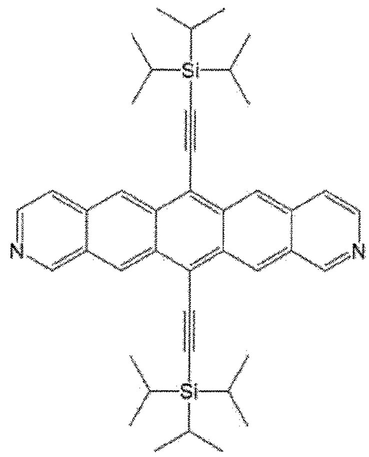

(D-7)

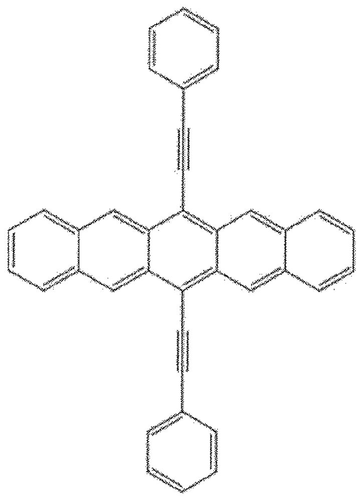

(D-8)

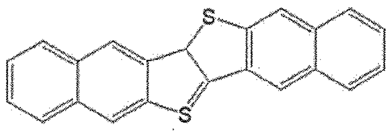

(D-9)

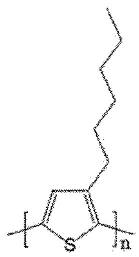

(D-10)

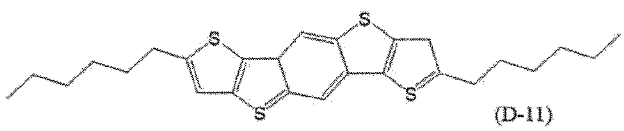

(D-11)

In the present invention, examples of a method for forming an organic semiconductor layer include: a method in which an organic semiconductor is deposited in vacuum; or a method in which an organic semiconductor is dissolved in an organic solvent, and is then applied or printed. The method is not particularly limited, provided that a thin film of an organic semiconductor layer can be formed. A solution concentration in a case where a solution in which the organic semiconductor layer has been dissolved in an organic solvent is applied or printed differs depending on a structure of the

organic semiconductor and a solvent used. From the viewpoint of forming a more uniform semiconductor layer and reducing a thickness of the layer, the solution concentration is preferably 0.5% to 5 wt%. The organic solvent used in this case is not particularly limited, provided that the organic semiconductor is dissolved in the organic solvent at a predetermined concentration at which the organic semiconductor can be formed into a film, and examples of the organic solvent include hexane, heptane, octane, decane, dodecane, tetradecane, hexadecane, decalin, indan, 1-methylnaphthalene, 2-ethylnaphthalene, 1,4-dimethylnaphthalene, a dimethylnaphthalene isomer mixture, toluene, xylene, ethylbenzene, 1,2,4-trimethylbenzene, mesitylene, isopropyl benzene, pentylbenzene, hexylbenzene, tetralin, octylbenzene, cyclohexylbenzene, 1,2-dichlorobenzene, 1,3-dichlorobenzene, 1,4-dichlorobenzene, trichlorobenzene, 1,2-dimethoxybenzene, 1,3-dimethoxybenzene, γ-butyrolactone, 1,3-butylene glycol, ethylene glycol, benzyl alcohol, glycerin, cyclohexanol acetate, 3-methoxy butyl acetate, ethylene glycol monomethyl ether acetate, ethylene glycol monobutyl ether acetate, propylene glycol monomethyl ether acetate, anisole, cyclohexanone, mesitylene, 3-methoxy butyl acetate, cyclohexanol acetate, dipropylene glycol diacetate, dipropylene glycol methyl ether acetate, diethylene glycol monobutyl ether acetate, diethylene glycol monoethyl ether acetate, 1,6-hexanediol diacetate, 1,3-butylene glycol diacetate, 1,4-butanediol diacetate, ethyl acetate, phenyl acetate, dipropylene glycol dimethyl ether, dipropylene glycol methyl-N-propyl ether, tetradecahydrophenanthrene, 1,2,3,4,5,6,7,8-octahydrophenanthrene, decahydro-2-naphthol, 1,2,3,4-tetrahydro-1-naphthol, α-terpineol, isophoronetriacetindecahydro-2-naphthol, dipropylene glycol dimethyl ether, 2,6-dimethylanisole, 1,2-dimethylanisole, 2,3-dimethylanisole, 3,4-dimethylanisole, 1-benzothiophene, 3-methylbenzothiophene, 1,2-dichloroethane, 1,1,2,2-tetrachloroethane, chloroform, dichloromethane, tetrahydrofuran, 1,2-dimethoxyethane, dioxane, cyclohexanone, acetone, methyl ethyl ketone, diethyl ketone, diisopropyl ketone, acetophenone, N,N-dimethylformamide, N-methyl-2-pyrolidone, limonene.

In order to obtain a crystalline film having a preferable property, a solvent having high solvency to dissolve an organic semiconductor and a boiling point of 100°C or more is suitable. Such a solvent is preferably xylene, isopropyl benzene, anisole, cyclohexanone, mesitylene, 1,2-dichlorobenzene, 3,4-dimethylanisol, pentylbenzene, tetralin, cyclohexylbenzene, or decahydro-2-naphthol. It is possible to use a mixed solvent in which two or more of the above solvents are mixed at an appropriate ratio.

To the organic semiconductor layer, various organic and inorganic polymers or oligomers, organic and inorganic nanoparticles as a solid, or a dispersion solution in which the nanoparticles are dispersed in water or an organic solvent can be added according to need. A polymer solution can be applied onto the above insulating layer to form a protective film. Moreover, it is possible to provide various kinds of moistureproof coating, lightfast coating, on the protective film according to need.

Examples of the gate electrode, the source electrode, or the drain electrode that can be used in the present invention include conductive materials such as: inorganic electrodes such as aluminum, gold, silver, copper, highly doped silicon, polysilicon, silicide, tin oxide, indium oxide, indium tin oxide, chromium, platinum, titanium, tantalum, graphene, carbon nanotubes: and organic electrodes such as a doped conductive polymer (e.g., PEDOT-PSS) or the like. A plurality of these conductive materials can be laminated and used. It is possible to carry out surface treatment using a surface treatment agent on these electrodes in order to increase carrier injection efficiency. Examples of such a surface treatment agent include benzenethiol, pentafluorobenzenethiol.

There is no particular limitation to a method of forming an electrode on the above substrate, insulating layer, or organic semiconductor layer. Examples of the method include deposition, high-frequency sputtering, electron beam sputtering. It is possible to employ a method in which solution spin coating, drop casting, dip coating, doctor blade, die coating, pad printing, roller coating, gravure printing, flexo printing, super flexo printing, screen printing, inkjet printing, letterpress reverse printing, or the like is carried out with use of ink in which nanoparticles of the above conductive material are dissolved in water or an organic solvent.

The fluorine-based resin of the present invention can be suitably used for a pattern and a protective film layer in an organic transistor.

From the viewpoint of practicality of an organic transistor element, the organic transistor in accordance with an aspect of the present invention has mobility of preferably 0.20 $cm^2/Vs$ or more.

From the viewpoint of practicality of an organic transistor element, the organic transistor in accordance with an aspect of the present invention has an on current-to-off current ratio of preferably $10^5$ or more.

From the viewpoint of practicality of an organic transistor element, the organic transistor in accordance with an aspect of the present invention preferably does not involve hysteresis of electric current between the source and the drain.

Examples

The following description will discuss the present invention in greater detail with reference to Examples. However, the present invention is not limited to the following Examples.

Examples employed the following conditions and devices.

<Monomer purity>

Gas chromatography device; manufactured by Shimadzu Corporation, (product name) GC2014
Column; manufactured by RESTEK, (product name) Rxi-1HT, 30 m
The above gas chromatography device (GC) was used to analyze purity of a monomer.

<Composition of fluorine-based resin>

With use of a nuclear magnetic resonance measurement device (manufactured by JEOL Ltd., product name: JNM-ECZ400S), a composition of a fluorine-based resin was obtained by proton nuclear magnetic resonance ($^1$H-NMR) spectroscopic analysis.

<Spin coating>

MS-A100 manufactured by MIKASA CO., LTD. was used.

<Measurement of film thickness>

Measurement was carried out using a DektakXT stylus profiler manufactured by Bruker.

<UV irradiation>

Using a UV mask aligner, UPE-1605MA manufactured by USHIO LIGHTING, INC., a UV irradiation time was adjusted by changing a transferring speed under a condition of UV intensity of 14.2 mW/cm$^2$.

<Inkjet printing>

A cartridge having a basic droplet rate of 10 pL was filled with a solution of an organic semiconductor (di-n-hexyldithienobenzodithiophene) synthesized in accordance with a production method of Japanese Patent Application Publication Tokukai No. 2015-224238. Then, printing was carried out using an inkjet device (manufactured by FUJIFILM Dimatix, DMP-2831, stage temperature: 30°C, cartridge temperature: 30°C).

<Laser microscope>

A laser microscope, OPTELICS HYBRID manufactured by Lasertec Corporation, was used to check an organic semiconductor layer or a pattern which has been inkjet-printed.
In Examples, the following results were obtained.

Synthesis Example 1 (synthesis of photocrosslinkable monomer 1)

Under a nitrogen atmosphere, 6 g of glycerin monomethacrylate (BLEMMER GLM, NOF CORPORATION), 8.6 g of triethylamine, and 18 g of tetrahydrofuran were introduced into a 200 mL flask, and the resultant mixture was sufficiently mixed together. Moreover, under a nitrogen atmosphere, 14.1 g of cinnamic acid chloride and 42 g of tetrahydrofuran were introduced into a glass vial and the resultant mixture was dissolved. Then, nitrogen was introduced into the flask containing the glycerin monomethacrylate, the triethylamine, and the tetrahydrofuran, and the solution in which the cinnamic acid chloride had been dissolved was dripped with used of a dripping funnel, and a resultant mixture was stirred for 22 hours. After that, the resultant mixture was filtered to remove a salt which is a by-product, and tetrahydrofuran was removed with use of an aspirator. Then, a resultant product was dissolved in 50 g of toluene, cleaned three times with an aqueous sodium hydrogencarbonate solution, and dried in vacuum. As a result of $^1$H-NMR and gas chromatography analysis of a substance obtained after the drying, it was found that the substance was a substance (photocrosslinkable monomer 1) represented by Formula (7) below. (GC purity: 87%)

(Photocrosslinkable monomer 1)

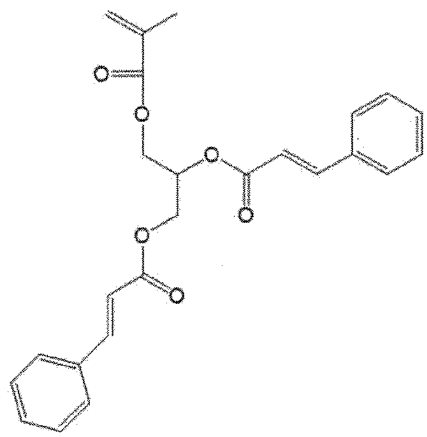

(7)

Example 1 (polymerization of fluorine-based resin 1)

Into a glass ampule having a capacity of 75 mL, 6.78 g of the photocrosslinkable monomer 1 obtained in Synthesis Example 1, 9.10 g of 1H,1H,2H,2H-tridecafluoro-n-octyl methacrylate, 0.27 g of PERHEXYL ND (manufactured by NOF CORPORATION) as a polymerization initiator, and 37 g of 2-butanone were introduced. Replacement of inside gas with nitrogen and depressurization were repeated, and then the glass ampule was sealed by welding in a reduced-pressure state. This ampule was put into a constant temperature bath at 45°C, and maintained for 24 hours to carry out radical polymerization. After the completion of the polymerization reaction, a polymer solution was taken out from the ampule, and the polymer solution was dripped onto 500 mL of methanol so as to be deposited, and then cleaned with 300 mL of methanol twice. Further, the cleaned substance was dried in vacuum at 30°C for 8 hours, and thus 13.8 g of a fluorine-based resin 1 was obtained (yield: approximately 87%). From $^{1}$H-NMR measurement of the fluorine-based resin 1, it was found that the composition thereof was as follows: photocrosslinkable monomer 1 (photocrosslinkable group unit 1) [B-1]/1H,1H,2H,2H-tridecafluoro-n-octyl methacrylate (fluorine-based unit) [C-29] = 38/62 (mol%), and the fluorine-based resin 1 was a copolymer represented by Formula (8). The result of $^{1}$H-NMR measurement is shown in Fig. 3.

(Fluorine-based resin 1)

Fluorine-based unit 1 Photocrosslinkable group unit 1

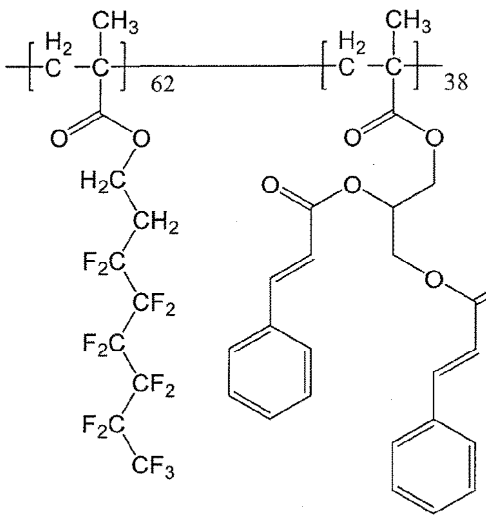

(8)

Synthesis Example 2 (synthesis of photocrosslinkable monomer 2)

Under a nitrogen atmosphere, 5 g of 4-chlorocinnamic acid, 7 g of thionyl chloride, 3 drops of N,N-dimethylformamide, and 20 mL of dichloromethane were added to a 50 mL Schlenk tube, a resultant mixture was caused to react together while being stirred at 40°C for 4 hours, dried in vacuum, and thus 4-chlorocinnamic acid chloride was obtained.

After that, under a nitrogen atmosphere, 1.7 g of glycerin monomethacrylate (BLEMMER GLM, NOF CORPORATION), 3 g of triethylamine, and 5.1 g of toluene were introduced into a 100 mL flask, and the resultant mixture was sufficiently mixed together. Moreover, under a nitrogen atmosphere, 5.3 g of 4-chlorocinnamic acid chloride and 16 g of toluene were introduced into a glass vial and the resultant mixture was dissolved. Then, nitrogen was introduced into the flask containing the glycerin monomethacrylate, the triethylamine, and the toluene, and the solution in which the pCl-cinnamic acid chloride had been dissolved was dripped with used of a dripping funnel, and a resultant mixture was stirred for 22 hours. After that, the resultant mixture was filtered to remove a salt which is a by-product. Then, a resultant product was cleaned three times with an aqueous sodium hydrogencarbonate solution, and dried in vacuum. As a result of $^1$H-NMR and gas chromatography analysis of a substance obtained after the drying, it was found that the substance was a compound (photocrosslinkable monomer 2) represented by Formula (9) below. (GC purity: 93%)

(Photocrosslinkable monomer 2)

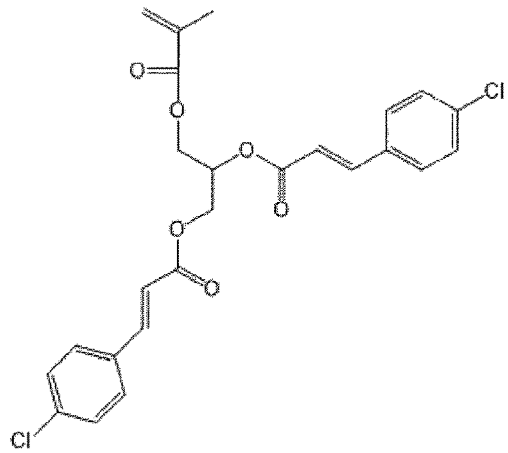

(9)

Example 2 (polymerization of fluorine-based resin 2)

Into a glass ampule having a capacity of 75 mL, 2.31 g of the photocrosslinkable monomer 2 obtained in Synthesis Example 2, 2.85 g of 1H,1H,2H,2H-tridecafluoro-n-octyl methacrylate, 0.09 g of PERHEXYL ND (manufactured by NOF CORPORATION) as a polymerization initiator, and 12 g of 2-butanone were introduced. Replacement of inside gas with nitrogen and depressurization were repeated, and then the glass ampule was sealed by welding in a reduced-pressure state. This ampule was put into a constant temperature bath at 45°C, and maintained for 24 hours to carry out radical polymerization. After the completion of the polymerization reaction, a polymer solution was taken out from the ampule, and the polymer solution was dripped onto 200 mL of methanol so as to be deposited, and then cleaned with 100 mL of methanol twice. Further, the cleaned substance was dried in vacuum at 30°C for 8 hours, and thus 3.0 g of a fluorine-based resin 2 was obtained (yield: approximately 61%). From $^1$H-NMR measurement of the fluorine-based resin 2, it was found that the composition thereof was as follows: photocrosslinkable monomer 2 (photocrosslinkable group unit 2) [B-13]/1H,1H,2H,2H-tridecafluoro-n-octyl methacrylate (fluorine-based unit 1) [C-29] = 36/64 (mol%), and the fluorine-based resin 2 was a copolymer represented by Formula (10).

(Fluorine-based resin 2)

Fluorine-based unit 1 Photocrosslinkable group unit 2

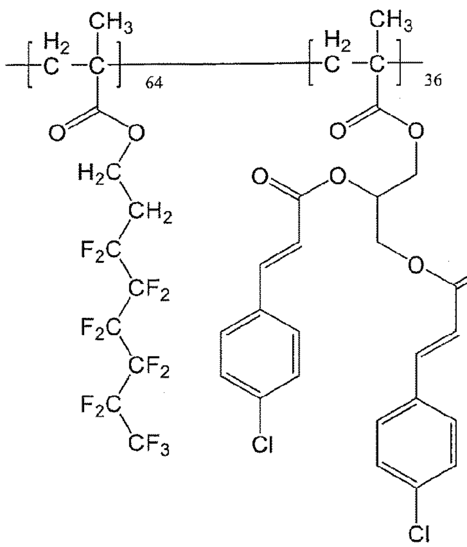

(10)

Synthesis Example 3 (synthesis of photocrosslinkable monomer 3)

Synthesis was carried out in a manner similar to that in Synthesis Example 2, except that (E)-3-(4-methylphenyl)-2-propenoate was used instead of 4-chlorocinnamic acid. As a result of analysis, it was found that the obtained substance was a compound (photocrosslinkable monomer 3) represented by Formula (11) below. (GC purity: 89%)

(Photocrosslinkable monomer 3)

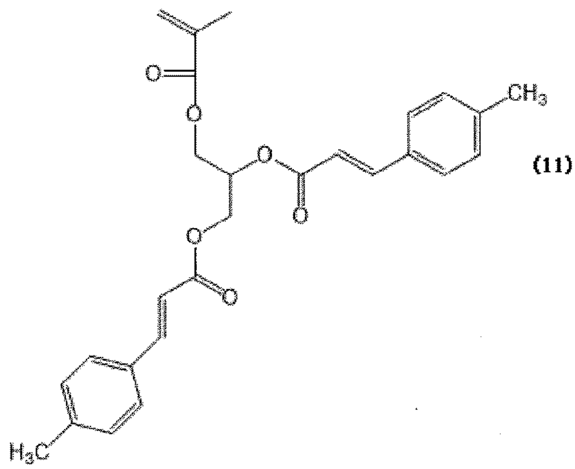

(11)

Example 3 (polymerization of fluorine-based resin 3)

Into a glass ampule having a capacity of 75 mL, 2.30 g of the photocrosslinkable monomer 3 obtained in Synthesis Example 3, 2.95 g of 1H,1H,2H,2H-tridecafluoro-n-octyl methacrylate, 0.09 g of PERHEXYL ND (manufactured by NOF CORPORATION) as a polymerization initiator, and 12 g of 2-butanone were introduced. Replacement of inside gas with nitrogen and depressurization were repeated, and then the glass ampule was sealed by welding in a reduced-pressure state. This ampule was put into a constant temperature bath at 45°C, and maintained for 24 hours to carry out radical polymerization. After the completion of the polymerization reaction, a polymer solution was taken out from the ampule, and the polymer solution was dripped onto 200 mL of methanol so as to be deposited, and then cleaned with 100 mL of methanol twice. Further, the cleaned substance was dried in vacuum at 30°C for 8 hours, and thus 4.2 g of a fluorine-based resin 3 was obtained (yield: approximately 84%). From $^1H$-NMR measurement of the fluorine-based resin 3, it was found that the composition thereof was as follows: photocrosslinkable monomer 3 (photocrosslinkable group unit 3)

[B-2]/1H,1H,2H,2H-tridecafluoro-n-octyl methacrylate (fluorine-based unit 1) [C-29] = 37/63 (mol%), and the fluorine-based resin 3 was a copolymer represented by Formula (12).

(Fluorine-based resin 3)

Fluorine-based unit 1 Photocrosslinkable group unit 3

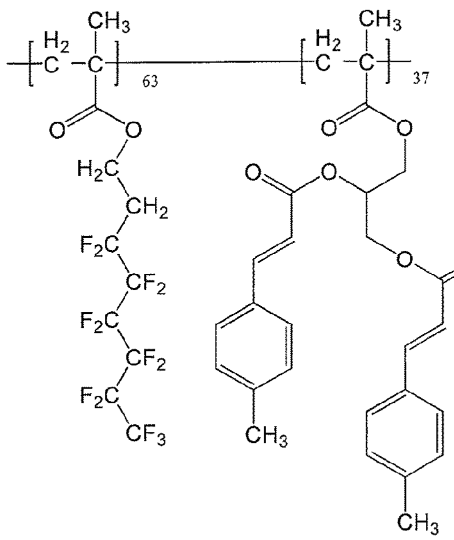

(12)

Synthesis Example 4 (synthesis of photocrosslinkable monomer 4)

Synthesis was carried out in a manner similar to that in Synthesis Example 2, except that 3-(trifluoromethyl) cinnamic acid was used instead of 4-chlorocinnamic acid. As a result of analysis, it was found that the obtained substance was a compound (photocrosslinkable monomer 4) represented by Formula (13) below. (GC purity: 81%)

(Photocrosslinkable monomer 4)

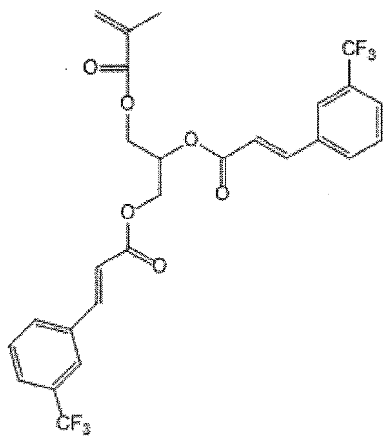

(13)

Example 4 (polymerization of fluorine-based resin 4)

Into a glass ampule having a capacity of 75 mL, 2.78 g of the photocrosslinkable monomer 4 obtained in Synthesis Example 4, 2.69 g of 1H,1H,2H,2H-tridecafluoro-n-octyl methacrylate, 0.08 g of PERHEXYL ND (manufactured by NOF CORPORATION) as a polymerization initiator, and 13 g of 2-butanone were introduced. Replacement of inside gas with nitrogen and depressurization were repeated, and then the glass ampule was sealed by welding in a reduced-pressure state. This ampule was put into a constant temperature bath at 45°C, and maintained for 24 hours to carry out radical polymerization. After the completion of the polymerization reaction, a polymer solution was taken out from the ampule, and the polymer solution was dripped onto 200 mL of methanol so as to be deposited, and then cleaned with 100 mL of methanol twice. Further, the cleaned substance was dried in vacuum at 30°C for 8 hours, and thus 4.1 g of a fluorine-based resin 4 was obtained (yield: approximately 82%). From $^1$H-NMR measurement of the fluorine-based resin 4, it was found that the composition thereof was as follows: photocrosslinkable monomer 4 (photocrosslinkable group unit 4) [B-16]/1H,1H,2H,2H-tridecafluoro-n-octyl methacrylate (fluorine-based unit 1) [B-29] = 37/63 (mol%), and the fluorine-based resin 4 was a copolymer represented by Formula (14).

(Fluorine-based resin 4)

Fluorine-based unit 1 Photocrosslinkable group unit 4

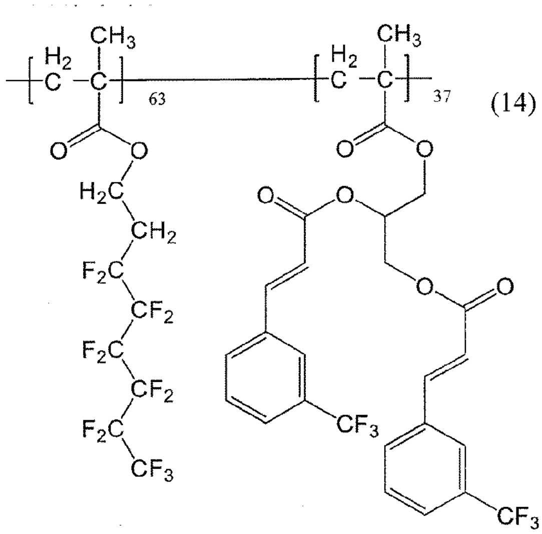

(14)

Example 5 (polymerization of fluorine-based resin 5)

Into a glass ampule having a capacity of 75 mL, 5.4 g of the photocrosslinkable monomer 1 obtained in Synthesis Example 1, 5.4 g of 1H,1H,2H,2H-nonafluorohexyl methacrylate, 0.21 g of PERHEXYL ND (manufactured by NOF CORPORATION) as a polymerization initiator, and 25 g of 2-butanone were introduced. Replacement of inside gas with nitrogen and depressurization were repeated, and then the glass ampule was sealed by welding in a reduced-pressure state. This ampule was put into a constant temperature bath at 45°C, and maintained for 24 hours to carry out radical polymerization. After the completion of the polymerization reaction, a polymer solution was taken out from the ampule, and the polymer solution was dripped onto 500 mL of methanol so as to be deposited, and then cleaned with 300 mL of methanol twice. Further, the cleaned substance was dried in vacuum at 30°C for 8 hours, and thus 8.4 g of a fluorine-based resin 5 was obtained (yield: approximately 83%). From $^1$H-NMR measurement of the fluorine-based resin 5, it was found that the composition thereof was as follows: photocrosslinkable monomer 1 (photocrosslinkable group unit 1) [B-1]/1H,1H,2H,2H-nonafluorohexyl methacrylate (fluorine-based unit 2) [C-27] = 39/61 (mol%), and the fluorine-based resin 5 was a copolymer represented by Formula (15).

(Fluorine-based resin 5)

Fluorine-based unit 2 Photocrosslinkable group unit 1

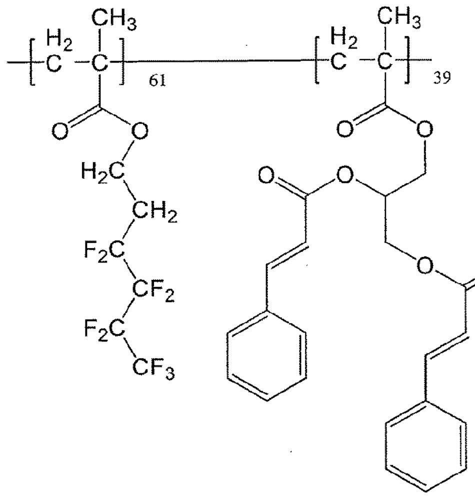

(15)

Example 6 (polymerization of fluorine-based resin 6)

Into a glass ampule having a capacity of 75 mL, 6.6 g of the photocrosslinkable monomer 1 obtained in Synthesis Example 1, 4.4 g of 2,2,3,3,3-pentafluoropropyl methacrylate, 0.26 g of PERHEXYL ND (manufactured by NOF CORPORATION) as a polymerization initiator, and 25 g of 2-butanone were introduced. Replacement of inside gas with nitrogen and depressurization were repeated, and then the glass ampule was sealed by welding in a reduced-pressure state. This ampule was put into a constant temperature bath at 45°C, and maintained for 24 hours to carry out radical polymerization. After the completion of the polymerization reaction, a polymer solution was taken out from the ampule, and the polymer solution was dripped onto 500 mL of methanol so as to be deposited, and then cleaned with 300 mL of methanol twice. Further, the cleaned substance was dried in vacuum at 30°C for 8 hours, and thus 7.0 g of a fluorine-based resin 6 was obtained (yield: approximately 69%). From $^1$H-NMR measurement of the fluorine-based resin 6, it was found that the composition thereof was as follows: photocrosslinkable monomer 1 (photocrosslinkable group unit 1) [B-1]/2,2,3,3,3-pentafluoropropyl methacrylate (fluorine-based unit 3) [C-25] = 39/61 (mol%), and the fluorine-based resin 6 was a copolymer represented by Formula (16).

(Fluorine-based resin 6)

Fluorine-based unit 3 Photocrosslinkable group unit 1

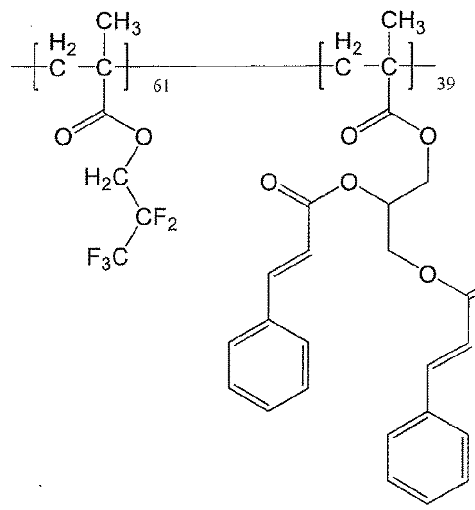

(16)

Example 7 (polymerization of fluorine-based resin 7)

Into a glass ampule having a capacity of 75 mL, 5.7 g of the photocrosslinkable monomer 1 obtained in Synthesis Example 1, 5.2 g of 1H,1H,5H-octafluoropentyl methacrylate, 0.22 g of PERHEXYL ND (manufactured by NOF CORPORATION) as a polymerization initiator, and 25 g of 2-butanone were introduced. Replacement of inside gas with nitrogen and depressurization were repeated, and then the glass ampule was sealed by welding in a reduced-pressure state. This ampule was put into a constant temperature bath at 45°C, and maintained for 24 hours to carry out radical polymerization. After the completion of the polymerization reaction, a polymer solution was taken out from the ampule, and the polymer solution was dripped onto 500 mL of methanol so as to be deposited, and then cleaned with 300 mL of methanol twice. Further, the cleaned substance was dried in vacuum at 30°C for 8 hours, and thus 4.3 g of a fluorine-based resin 7 was obtained (yield: approximately 43%). From $^1$H-NMR measurement of the fluorine-based resin 7, it was found that the composition thereof was as follows: photocrosslinkable monomer 1 (photocrosslinkable group unit 1) [B-1]/1H,1H,5H-octafluoropentyl methacrylate (fluorine-based unit 4) [C-23] = 40/60 (mol%), and the fluorine-based resin 7 was a copolymer represented by Formula (17).

(Fluorine-based resin 7)

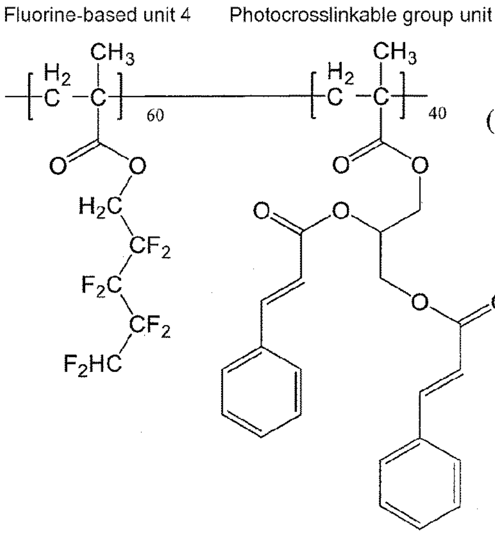


(17)

Example 8 (polymerization of fluorine-based resin 8)

Into a glass ampule having a capacity of 75 mL, 4.8 g of the photocrosslinkable monomer 1 obtained in Synthesis Example 1, 5.9 g of 2,2,3,3,4,4,5,5,6,6,7,7-dodecafluoroheptyl methacrylate, 0.19 g of PERHEXYL ND (manufactured by NOF CORPORATION) as a polymerization initiator, and 25 g of 2-butanone were introduced. Replacement of inside gas with nitrogen and depressurization were repeated, and then the glass ampule was sealed by welding in a reduced-pressure state. This ampule was put into a constant temperature bath at 45°C, and maintained for 24 hours to carry out radical polymerization. After the completion of the polymerization reaction, a polymer solution was taken out from the ampule, and the polymer solution was dripped onto 500 mL of methanol so as to be deposited, and then cleaned with 300 mL of methanol twice. Further, the cleaned substance was dried in vacuum at 30°C for 8 hours, and thus 0.8 g of a fluorine-based resin 8 was obtained (yield: approximately 8%). From $^1$H-NMR measurement of the fluorine-based resin 8, it was found that the composition thereof was as follows: photocrosslinkable monomer 1 (photocrosslinkable group unit 1) [B-1]/2,2,3,3,4,4,5,5,6,6,7,7-dodecafluoroheptyl methacrylate (fluorine-based unit 5) [C-24] = 41/59 (mol%), and the fluorine-based resin 8 was a copolymer represented by Formula (18).

(Fluorine-based resin 8)

Fluorine-based unit 5 Photocrosslinkable group unit 1

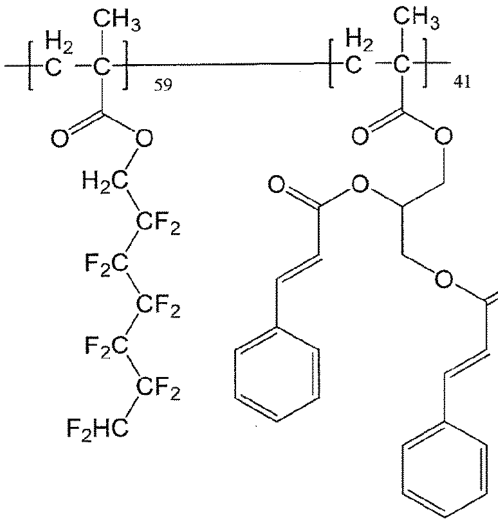

(18)

Example 9 (polymerization of fluorine-based resin 9)

Into a glass ampule having a capacity of 75 mL, 8.2 g of the photocrosslinkable monomer 1 obtained in Synthesis Example 1, 3.1 g of 1H,1H,2H,2H-tridecafluoro-n-octyl methacrylate, 0.18 g of PERHEXYL ND (manufactured by NOF CORPORATION) as a polymerization initiator, and 26 g of 2-butanone were introduced. Replacement of inside gas with nitrogen and depressurization were repeated, and then the glass ampule was sealed by welding in a reduced-pressure state. This ampule was put into a constant temperature bath at 45°C, and maintained for 24 hours to carry out radical polymerization. After the completion of the polymerization reaction, a polymer solution was taken out from the ampule, and the polymer solution was dripped onto 500 mL of methanol so as to be deposited, and then cleaned with 300 mL of methanol twice. Further, the cleaned substance was dried in vacuum at 30°C for 8 hours, and thus 8.8 g of a fluorine-based resin 9 was obtained (yield: approximately 88%). From $^1$H-NMR measurement of the fluorine-based resin 9, it was found that the composition thereof was as follows: photocrosslinkable monomer 1 (photocrosslinkable group unit 1) [B-1]/1H,1H,2H,2H-tridecafluoro-n-octyl methacrylate (fluorine-based unit 1) [C-29] = 26/74 (mol%), and the fluorine-based resin 9 was a copolymer represented by Formula (19).

(Fluorine-based resin 9)

Fluorine-based unit 1 Photocrosslinkable group unit 1

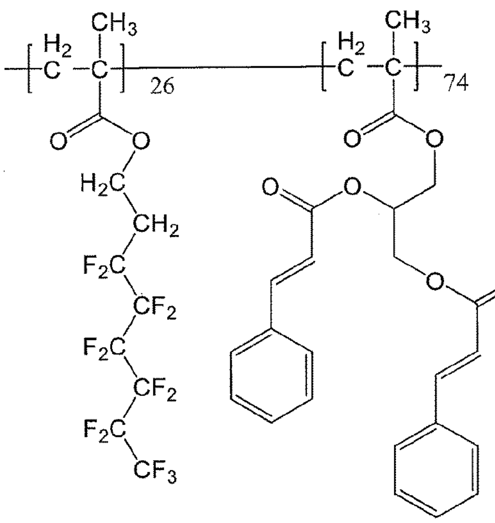

(19)

Example 10 (polymerization of fluorine-based resin 10)

Into a glass ampule having a capacity of 75 mL, 10.6 g of the photocrosslinkable monomer 1 obtained in Synthesis Example 1, 1.0 g of 1H,1H,2H,2H-tridecafluoro-n-octyl methacrylate, 0.18 g of PERHEXYL ND (manufactured by NOF CORPORATION) as a polymerization initiator, and 27 g of 2-butanone were introduced. Replacement of inside gas with nitrogen and depressurization were repeated, and then the glass ampule was sealed by welding in a reduced-pressure state. This ampule was put into a constant temperature bath at 45°C, and maintained for 24 hours to carry out radical polymerization. After the completion of the polymerization reaction, a polymer solution was taken out from the ampule, and the polymer solution was dripped onto 500 mL of methanol so as to be deposited, and then cleaned with 300 mL of methanol twice. Further, the cleaned substance was dried in vacuum at 30°C for 8 hours, and thus 8.2 g of a fluorine-based resin 10 was obtained (yield: approximately 82%). From $^1$H-NMR measurement of the fluorine-based resin 10, it was found that the composition thereof was as follows: photocrosslinkable monomer 1 (photocrosslinkable group unit 1) [B-1]/1H,1H,2H,2H-tridecafluoro-n-octyl methacrylate (fluorine-based unit 1) [C-29] = 15/85 (mol%), and the fluorine-based resin 10 was a copolymer represented by Formula (20).

(Fluorine-based resin 10)

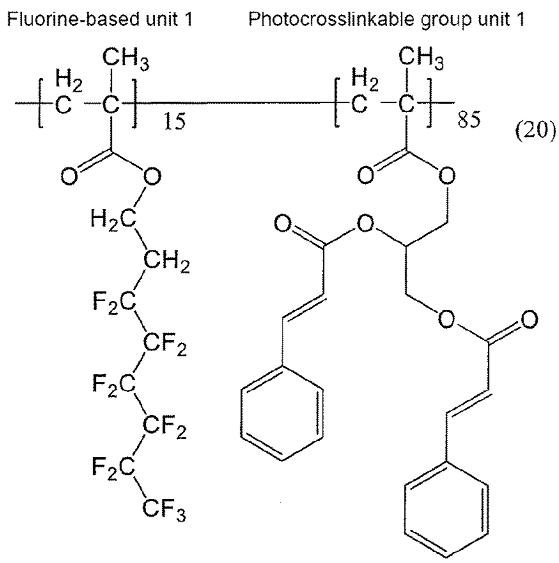

(20)

Example 11 (production of fluorine-based resin 11)

Into a glass ampule having a capacity of 15 mL, 0.81 g of the photocrosslinkable monomer 1 obtained in Synthesis Example 1, 0.35 g of 1H,1H,2H,2H-tridecafluoro-n-octyl methacrylate, 0.16 g of methyl methacrylate, 0.03 g of PERHEXYL ND (manufactured by NOF CORPORATION) as a polymerization initiator, and 3.1 g of 2-butanone were introduced. Replacement of inside gas with nitrogen and depressurization were repeated, and then the glass ampule was sealed by welding in a reduced-pressure state. This ampule was put into a constant temperature bath at 45°C, and maintained for 24 hours to carry out radical polymerization. After the completion of the polymerization reaction, a polymer solution was taken out from the ampule, and the polymer solution was dripped onto 100 mL of methanol so as to be deposited, and then cleaned with 100 mL of methanol twice. Further, the cleaned substance was dried in vacuum at 30°C for 8 hours, and thus 1.1 g of a fluorine-based resin 11 was obtained (yield: approximately 83%). From $^1$H-NMR measurement of the fluorine-based resin 11, it was found that the composition thereof was as follows: photocrosslinkable monomer 1 (photocrosslinkable group unit 1) [B-1]/1H,1H,2H,2H-tridecafluoro-n-octyl methacrylate (fluorine-based unit 1) [C-29]/methyl methacrylate (non-fluorine-based unit) = 36/22/42 (mol%), and the fluorine-based resin 11 was a copolymer represented by Formula (21) below.

(Fluorine-based resin 11)

Fluorine-based unit 1 Photocrosslinkable group unit 1 Non-fluorine-based unit

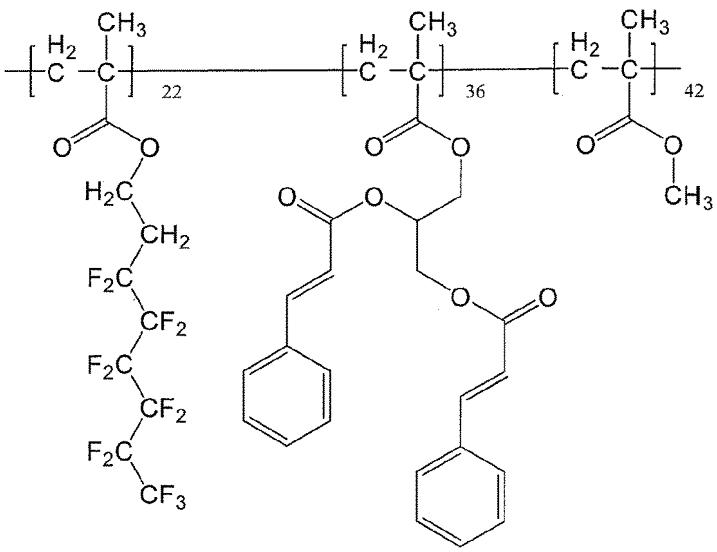

(21)

Synthesis Example 5 (synthesis of photocrosslinkable monomer 5)

Synthesis was carried out in a manner similar to that in Synthesis Example 2, except that 4-(trifluoromethyl) cinnamic acid was used instead of 4-chlorocinnamic acid. As a result of analysis, it was found that the obtained substance was a compound (photocrosslinkable monomer 5) represented by Formula (22) below. (GC purity: 83%)

(Photocrosslinkable monomer 5)

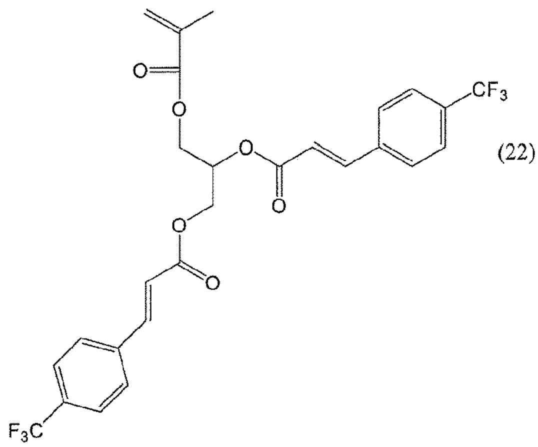

(22)

Example 12 (polymerization of fluorine-based resin 12)

Into a glass ampule having a capacity of 75 mL, 2.69 g of the photocrosslinkable monomer 5 obtained in Synthesis Example 5, 2.78 g of 1H,1H,2H,2H-tridecafluoro-n-octyl methacrylate, 0.08 g of PERHEXYL ND (manufactured by NOF CORPORATION) as a polymerization initiator, and 13 g of 2-butanone were introduced. Replacement of inside gas with nitrogen and depressurization were repeated, and then the glass ampule was sealed by welding in a reduced-pressure state. This ampule was put into a constant temperature bath at 45°C, and maintained for 24 hours to carry out radical polymerization. After the completion of the polymerization reaction, a polymer solution was taken out from the ampule, and the polymer solution was dripped onto 200 mL of methanol so as to be deposited, and then cleaned with 100 mL of methanol twice. Further, the cleaned substance was dried in vacuum at 30°C for 8 hours, and thus 4.1 g of a fluorine-based resin 12 was obtained (yield: approximately 83%). From $^1$H-NMR measurement of the fluorine-based resin 12, it was found that the composition thereof was as follows: photocrosslinkable monomer 5 (photocrosslinkable group unit 5)

[B-15]/ 1H,1H,2H,2H-tridecafluoro-n-octyl methacrylate (fluorine-based unit 1) [B-29] = 36/64 (mol%), and the fluorine-based resin 12 was a copolymer represented by Formula (23).

(Fluorine-based resin 12)

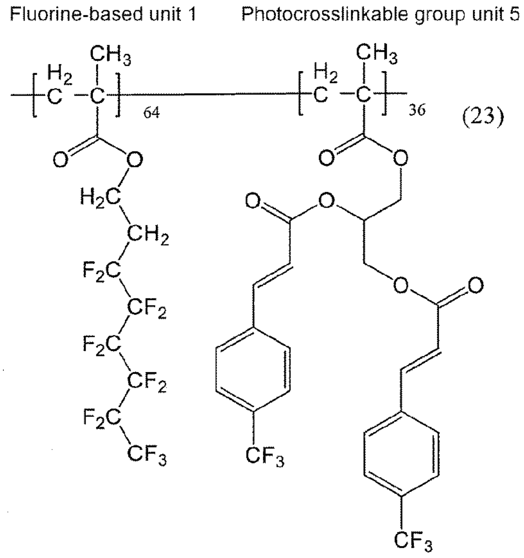


(23)

Comparative Example 1 (polymerization of non-fluorine-based resin 1)

Into a glass ampule having a capacity of 75 mL, 4.36 g of the photocrosslinkable monomer 1 obtained in Synthesis Example 1, 1.32 g of methyl methacrylate, 0.17 g of PERHEXYL ND (manufactured by NOF CORPORATION) as a polymerization initiator, and 13 g of 2-butanone were introduced. Replacement of inside gas with nitrogen and depressurization were repeated, and then the glass ampule was sealed by welding in a reduced-pressure state. This ampule was put into a constant temperature bath at 45°C, and maintained for 24 hours to carry out radical polymerization. After the completion of the polymerization reaction, a polymer solution was taken out from the ampule, and the polymer solution was dripped onto 500 mL of methanol so as to be deposited, and then cleaned with 300 mL of methanol twice. Further, the cleaned substance was dried in vacuum at 30°C for 8 hours, and thus 4.6 g of a non-fluorine-based resin 1 was obtained (yield: approximately 81%). From $^1$H-NMR measurement of the non-fluorine-based resin 1, it was found that the composition thereof was as follows: photocrosslinkable monomer 1 (photocrosslinkable group unit 1)/methyl methacrylate (non-fluorine-based unit) = 38/62 (mol%), and the non-fluorine-based resin 1 was a copolymer represented by Formula (24) below.

(Non-fluorine-based resin 1)

Non-fluorine-based unit Photocrosslinkable group unit 1

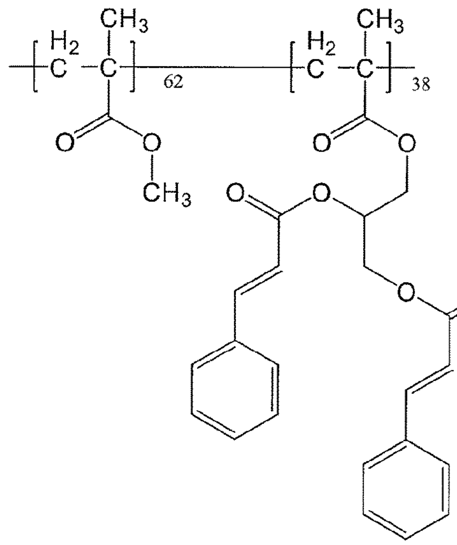

(24)

Synthesis Example 6 (synthesis of photocrosslinkable monomer 6)

Under a nitrogen atmosphere, 6 g of 2-hydroxyethyl methacrylate, 5.3 g of triethylamine, and 18 g of tetrahydrofuran were introduced into a 200 mL flask, and the resultant mixture was sufficiently mixed together. Moreover, under a nitrogen atmosphere, 8.7 g of cinnamic acid chloride and 26 g of tetrahydrofuran were introduced into a glass vial and the resultant mixture was dissolved. Then, nitrogen was introduced into the flask containing the 2-hydroxyethyl methacrylate, the triethylamine, and the tetrahydrofuran, and the solution in which the cinnamic acid chloride had been dissolved was dripped with used of a dripping funnel, and a resultant mixture was stirred for 22 hours. After that, the resultant mixture was filtered to remove a salt which is a by-product, and tetrahydrofuran was removed with use of an aspirator. Then, a resultant product was dissolved in 50 g of toluene, cleaned three times with an aqueous sodium hydrogencarbonate solution, and dried in vacuum. As a result of $^{1}$H-NMR and gas chromatography of a substance obtained after the drying, it was found that the substance was a substance (photocrosslinkable monomer 6) represented by Formula (25) below. (GC purity: 91%)

(Photocrosslinkable monomer 6)

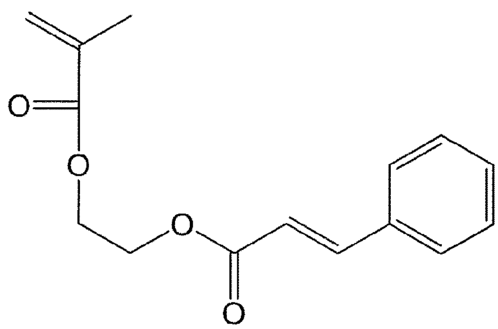

(25)

Comparative Example 2 (polymerization production of fluorine-based resin 13)

Into a glass ampule having a capacity of 75 mL, 3.11 g of the photocrosslinkable monomer 2 obtained in Synthesis Example 2, 7.14 g of 1H,1H,2H,2H-tridecafluoro-n-octyl methacrylate, 0.21 g of PERHEXYL ND (manufactured by NOF CORPORATION) as a polymerization initiator, and 24 g of 2-butanone were introduced. Replacement of inside gas with nitrogen and depressurization were repeated, and then the glass ampule was sealed by welding in a reduced-pressure state. This ampule was put into a constant temperature bath at 45°C, and maintained for 24 hours to carry out radical polymerization. After the completion of the polymerization reaction, a polymer solution was taken out from the ampule, and the polymer solution was dripped onto 500 mL of methanol so as to be deposited, and then cleaned with 300 mL of

methanol twice. Further, the cleaned substance was dried in vacuum at 30°C for 8 hours, and thus 9.2 g of a fluorine-based resin 13 was obtained (yield: approximately 90%). From $^1$H-NMR measurement of the fluorine-based resin 13, it was found that the composition thereof was as follows: photocrosslinkable monomer 6 (photocrosslinkable group unit 6)/1H,1H,2H,2H-tridecafluoro-n-octyl methacrylate (fluorine-based unit) = 38/62 (mol%), and the fluorine-based resin 13 was a copolymer represented by Formula (26).

(Fluorine-based resin 13)

Fluorine-based unit 1 Photocrosslinkable group unit 6

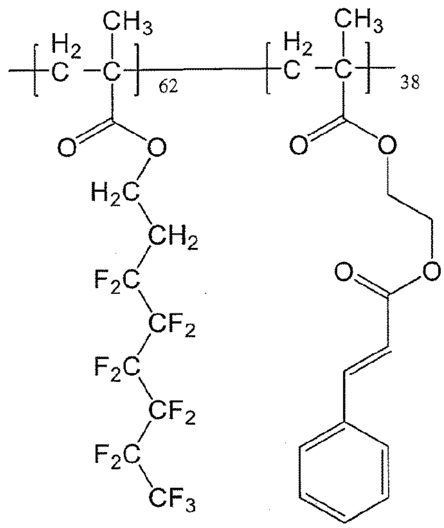

(26)

<Evaluation of solubility in fluorine-based solvent>

Each of the synthesized fluorine-based resins 1 through 12 and non-fluorine-based resin 1 was added to each of the following fluorine-based solvents (solvents 1 through 8) so that an amount of the resin in a resultant mixture was 3 wt%, and the mixture was mixed while being heated to 50°C. Then, the temperature was lowered to normal temperature, and whether or not there was an insoluble component or a deposited component was visually checked. Results are shown in Table 1. In Table 1, the presence of an insoluble component or a deposited component is indicated as "insoluble", and the absence of such components is indicated as "dissolved".

Solvent 1: 2H,3H-decafluoropentane
Solvent 2: 1,1,2,2,3,3,4-heptafluorocyclopentane
Solvent 3: 1,1,2,2-tetrafluoroethyl-2,2,2-trifluoroethylether
Solvent 4: Hexafluorobenzene
Solvent 5: 2,2,3,3-tetrafluoro-1-propanol
Solvent 6: 2,2,3,3,4,4,5,5-octafluoro-1-pentanol
Solvent 7: 1H,1H,7H-dodecafluoro-1-heptanol
Solvent 8: 2,2,3,3,4,4,4-heptafluoro-1-butanol

It was found that the fluorine-based resins 1 through 12 were dissolved in many of the fluorine-based solvents.

[Table 1]

| | Resin | Solvent 1 | Solvent 2 | Solvent 3 | Solvent 4 | Solvent 5 | Solvent 6 | Solvent 7 | Solvent 8 |
|---|---|---|---|---|---|---|---|---|---|
| Example 1 | Fluorine-based resin 1 | Dissolved | Dissolved | Dissolved | Dissolved | Dissolved | Dissolved | Dissolved | Dissolved |
| Example 2 | Fluorine-based resin 2 | Dissolved | Dissolved | Dissolved | Dissolved | Insoluble | Dissolved | Dissolved | Dissolved |
| Example 3 | Fluorine-based resin 3 | Dissolved | Dissolved | Dissolved | Dissolved | Insoluble | Dissolved | Dissolved | Dissolved |
| Example 4 | Fluorine-based resin 4 | Dissolved | Dissolved | Dissolved | Dissolved | Insoluble | Dissolved | Dissolved | Dissolved |
| Example 5 | Fluorine-based resin 5 | Insoluble | Dissolved | Dissolved | Dissolved | Dissolved | Dissolved | Dissolved | Dissolved |
| Example 6 | Fluorine-based resin 6 | Insoluble | Insoluble | Insoluble | Dissolved | Dissolved | Dissolved | Dissolved | Dissolved |
| Example 7 | Fluorine-based resin 7 | Insoluble | Dissolved | Insoluble | Dissolved | Dissolved | Dissolved | Dissolved | Insoluble |
| Example 8 | Fluorine-based resin 8 | Insoluble | Dissolved | Insoluble | Dissolved | Dissolved | Dissolved | Dissolved | Dissolved |
| Example 9 | Fluorine-based resin 9 | Insoluble | Insoluble | Insoluble | Dissolved | Dissolved | Dissolved | Dissolved | Dissolved |
| Example 10 | Fluorine-based resin 10 | Insoluble | Insoluble | Insoluble | Insoluble | Dissolved | Dissolved | Dissolved | Insoluble |
| Example 11 | Fluorine-based resin 11 | Insoluble | Insoluble | Insoluble | Dissolved | Dissolved | Dissolved | Dissolved | Dissolved |
| Example 11 | Fluorine-based resin 12 | Dissolved | Dissolved | Dissolved | Dissolved | Insoluble | Dissolved | Dissolved | Dissolved |
| Comparative Example 1 | Non-fluorine-based resin 1 | Insoluble | Insoluble | Insoluble | Insoluble | Dissolved | Dissolved | Dissolved | Dissolved |

<Evaluation of liquid-repellency (water-repellency, oil-repellency)>

A solution of each of the fluorine-based resins 1 through 11 and the non-fluorine-based resin 1 (3 wt%, solvent: propylene glycol monomethyl ether acetate) was spin-coated onto a cleaned and dried glass having a size of 30 × 30 $mm^2$ (EagleXG manufactured by Corning) under conditions of 500 rpm × 5 seconds and 1500 rpm × 20 seconds. When UV irradiation was carried out, irradiation with ultraviolet rays of 500 $mJ/cm^2$ was carried out. Using a contact angle meter (manufactured by Kyowa Interface Science Co., Ltd., product name: DM-300), contact angles were measured with respect to water, diiodomethane, m-xylene, and tetralin by the θ/2 method. Results are shown in Table 2.

It was found that the fluorine-based resins 1 through 12 had excellent liquid-repellency. In contrast, the non-fluorine-based resin 1 did not have excellent liquid-repellency.

[Table 2]

| Kind | Resin | Contact angle (°) | | | |
|---|---|---|---|---|---|
| | | Water | Diiodomethane | Tetralin | Xylene |
| Example 1 | Fluorine-based resin 1 | 116 | 93 | 76 | 66 |
| Example 2 | Fluorine-based resin 2 | 114 | 89 | 76 | 70 |
| Example 3 | Fluorine-based resin 3 | 114 | 87 | 76 | 68 |
| Example 4 | Fluorine-based resin 4 | 109 | 90 | 74 | 59 |
| Example 5 | Fluorine-based resin 5 | 110 | 86 | 70 | 60 |
| Example 6 | Fluorine-based resin 6 | 101 | 78 | 61 | 45 |
| Example 7 | Fluorine-based resin 7 | 93 | 72 | 48 | 27 |
| Example 8 | Fluorine-based resin 8 | 100 | 77 | 52 | 33 |
| Example 9 | Fluorine-based resin 9 | 112 | 86 | 70 | 60 |
| Example 10 | Fluorine-based resin 10 | 100 | 70 | 52 | 42 |
| Example 11 | Fluorine-based resin 11 | 109 | 83 | 66 | 58 |
| Comparative Example 1 | Non-fluorine-based resin 1 | 78 | 34 | <5 | <5 |

<Evaluation of photocrosslinking (curing) property>

A solution of each of the fluorine-based resins 1 through 11 and the fluorine-based resin 13 or a solution further containing a sensitizer (for solutions used, see Table 3) was spin-coated, with a spin coater, onto a cleaned and dried glass substrate having a size of 30 × 30 $mm^2$ (EagleXG manufactured by Corning) to form a film having a film thickness of 100 nm to 150 nm after drying, and a resultant film was sufficiently dried. This fluorine-based resin was irradiated with ultraviolet rays of 50 $mJ/cm^2$ to 500 $mJ/cm^2$ so that the resin film was photocrosslinked. The thickness of this film was measured with the DektakXT stylus profiler manufactured by Bruker, and the thickness was indicated as $T_0$. Next, the glass plate coated with the photocrosslinked resin film was immersed in acetone, which is a good solvent for a fluorine-based resin, for 1 minute, and then taken out. The film thickness was measured after drying at 100°C for 1 minute using a hot plate, and the thickness was indicated as $T_1$. Using these measured film thicknesses, a residual film ratio (R) was calculated based on the following equation.

$$R = T_1/T_0 \times 100\ (\%)$$

Photocrosslinking (curing) property was evaluated using a residual film ratio (R) of 95% or more as a determination criterion for crosslinking. Note that, as a UV radiation quantity for reaching a residual film ratio of 95% or more is lower, photocrosslinkability is higher (faster). Resins which achieved R of 95% or more with the UV radiation quantity of 500 $mJ/cm^2$ or less were determined to be "crosslinked", and resins which did not achieve R of 95% or more with the UV radiation quantity of 500 $mJ/cm^2$ or less were determined to be "insufficiently crosslinked". Results are shown in Table 3.

Solvent 6: 2,2,3,3,4,4,5,5-octafluoro-1-pentanol
Solvent 9: Propylene glycol monomethyl ether acetate

Sensitizer 1: 4,4'-bis(diethylamino)benzophenone (manufactured by Tokyo Chemical Industry Co., Ltd.)

[Table 3]

| | Solution | | | Solution concentration (%) | | Residual film ratio (%) for each UV radiation quantity (mJ,cm$^2$) | | | | Determination of crosslinking |
|---|---|---|---|---|---|---|---|---|---|---|
| | Resin | Solvent | Sensitizer | Resin | Sensitizer | 50 | 100 | 250 | 500 | |
| Example 1 | Fluorine-based resin 1 | 6 | - | 3 | - | - | 71 | 95 | 100 | Crosslinked |
| | | | 1 | 3 | 0.1 | 95 | 97 | - | - | Crosslinked |
| Example 2 | Fluorine-based resin 2 | 6 | - | 3 | - | - | 100 | 103 | 103 | Crosslinked |
| | | | 1 | 3 | 0.1 | 98 | - | - | - | Crosslinked |
| Example 3 | Fluorine-based resin 3 | 6 | - | 3 | - | - | 94 | 100 | 103 | Crosslinked |
| | | | 1 | 3 | 0.1 | 100 | - | - | - | Crosslinked |
| Example 4 | Fluorine-based resin 4 | 6 | - | 3 | - | - | 0 | 74 | 100 | Crosslinked |
| | | | 1 | 3 | 0.1 | 95 | - | - | - | Crosslinked |
| Example 5 | Fluorine-based resin 5 | 6 | - | 3 | - | - | 65 | 100 | 100 | Crosslinked |
| | | | 1 | 3 | 0.1 | 95 | - | - | - | Crosslinked |
| Example 6 | Fluorine-based resin 6 | 6 | - | 3 | - | - | 69 | 96 | 102 | Crosslinked |
| | | | 1 | 3 | 0.1 | - | 96 | - | - | Crosslinked |
| Example 7 | Fluorine-based resin 7 | 6 | - | 3 | - | - | 97 | 100 | 100 | Crosslinked |
| | | | 1 | 3 | 0.1 | 97 | - | - | - | Crosslinked |
| Example 8 | Fluorine-based resin 8 | 6 | - | 3 | - | - | 99 | 102 | 100 | Crosslinked |
| Example 9 | Fluorine-based resin 9 | 6 | - | 3 | - | - | 86 | 98 | 101 | Crosslinked |
| | | | 1 | 3 | 0.1 | 99 | - | - | - | Crosslinked |
| Example 10 | Fluorine-based resin 10 | 6 | - | 3 | - | - | 83 | 95 | 100 | Crosslinked |
| | | | 1 | 3 | 0.1 | 97 | - | - | - | Crosslinked |
| Example 11 | Fluorine-based resin 11 | 9 | - | 3 | - | - | 78 | 99 | 99 | Crosslinked |
| | | | 1 | 3 | 0.1 | - | 97 | - | - | Crosslinked |
| Comparative Example 2 | Fluorine-based resin 13 | 6 | - | 3 | - | - | 0 | 23 | 44 | insufficiently crosslinked |

<Pattern formation and evaluation of selective application of semiconductor solution>

For pattern formation, each of the fluorine-based resins 1 through 11 and the non-fluorine-based resin 1 was dissolved in a propylene glycol monomethyl ether acetate solvent, and thus a 3 wt% solution was prepared. As a mask for pattern formation, a mask patterned with chromium was used. The mask had a shape constituted by squares each of which had sides of 50 μm and which were arranged in a matrix of 10 × 10. On a glass substrate having a size of 100 × 100 mm$^2$,

the above solution was spin-coated to obtain a film, and the mask was provided on the obtained film, and the film was irradiated with UV rays of 300 $mJ/cm^2$. After the irradiation, uncrosslinked portions were cleaned and removed with acetone for 1 minute, and whether or not a pattern having the shape with 100 holes each having a size of $50 \times 50\ \mu m^2$ was formed on the film was checked using a laser microscope.

Next, selective application of the semiconductor solution was evaluated. To the inside of the pattern (i.e., a region from which each of the fluorine-based resins 1 through 11 and the non-fluorine-based resin 1 has been removed; hereinafter the same applies), a 0.8 wt% tetralin solution of the organic semiconductor (di-n-hexyldithienobenzodithiophene) represented by the above Formula (D-11) above was inkjet-printed. After the printing, whether or not the semiconductor solution formed a semiconductor layer inside the pattern without wetting the outside of the pattern (i.e., a region in which each of the fluorine-based resins 1 through 11 and the non-fluorine-based resin 1 has not been removed) was checked using a laser microscope. Results are shown in Table 4. Note that the organic semiconductor represented by Formula (D-11) was synthesized in accordance with the method disclosed in Japanese Patent Application Publication Tokukai No. 2012-209329.

[Table 4]

| | Resin | Pattern formation | Evaluation of selective application of semiconductor solution |
|---|---|---|---|
| Example 1 | Fluorine-based resin 1 | Formed | Selective application is possible |
| Example 2 | Fluorine-based resin 2 | Formed | Selective application is possible |
| Example 3 | Fluorine-based resin 3 | Formed | Selective application is possible |
| Example 4 | Fluorine-based resin 4 | Formed | Selective application is possible |
| Example 5 | Fluorine-based resin 5 | Formed | Selective application is possible |
| Example 6 | Fluorine-based resin 6 | Formed | Selective application is possible |
| Example 7 | Fluorine-based resin 7 | Formed | Selective application is possible |
| Example 8 | Fluorine-based resin 8 | Formed | Selective application is possible |
| Example 9 | Fluorine-based resin 9 | Formed | Selective application is possible |
| Example 10 | Fluorine-based resin 10 | Formed | Selective application is possible |
| Example 11 | Fluorine-based resin 11 | Formed | Selective application is possible |
| Comparative Example 1 | Non-fluorine-based resin 1 | Formed | Selective application is impossible |

<Evaluation of organic transistor>

(Formation of gate electrode)

A glass substrate having a size of $100 \times 100\ mm^2$ was placed in a sputtering device (SHIBAURA MECHATRONICS CORPORATION, CFS-4EP-LL), and silver was formed into a film of 50 nm. Then, the film was patterned with photolithography, and thus a silver electrode, i.e., a gate electrode was formed.

(Formation of insulating layer)

On the substrate on which the above gate electrode had been formed, an insulating layer was formed using a parylene deposition device (Parylene Japan, PDS2010) so that a film thickness of Parylene C was approximately 500 nm.

(Formation of source and drain electrodes)

The above substrate on which the insulating layer had been formed was placed in the sputtering device, and silver was formed into a film of 50 nm at 200 W. Then, the film was patterned with photolithography, and thus source and drain electrodes with a channel length of 20 μm and a channel width of 50 μm were formed.

(Formation of liquid-repellent pattern)

A 2-methoxy-1-methylethyl acetate solution (3 wt%) of each of the fluorine-based resins 1 through 11 was

prepared, and spin-coated onto the substrate, on which the source and drain electrodes had been formed, so that a film thickness was approximately 100 nm, and was dried at 100°C for 1 minute. After that, a mask having a rectangular light blocking section in a size of 30 μm × 60 μm was aligned so that a center of the light blocking section coincides with a center between the source electrode and the drain electrode, and then the mask was brought into contact with the substrate and irradiated with ultraviolet rays at 250 mJ/$cm^2$ to crosslink an area other than the light blocking section. After the ultraviolet irradiation, the substrate was cleaned with acetone for 1 minute, and then blow-dried with nitrogen gas. The fluorine-based resin present on the light blocking section of the above mask was removed, and thus a liquid-repellent pattern was formed.

(Electrode surface modification)

The above substrate on which the source and drain electrodes had been formed was immersed in an isopropyl alcohol solution of pentafluorobenzenethiol (30 mmol/L) for 5 minutes, and thus the surface of the electrodes formed on the substrate was modified.

(Preparation of solution for organic semiconductor layer formation)

Under air, 24 mg of the organic semiconductor (di-n-hexyldithienobenzodithiophene) represented by Formula (D-11) above, 3 mg of polystyrene (manufactured by Sigma-Aldrich, average Mw: 280,000), and 2,973 mg of tetralin (manufactured by Sigma-Aldrich) were introduced into a 10 mL sampling tube, and the organic semiconductor and polystyrene were dissolved by heating at 50°C, and thus a solution for organic semiconductor layer formation was prepared. Note that the organic semiconductor represented by Formula (D-11) was synthesized in accordance with the method disclosed in Japanese Patent Application Publication Tokukai No. 2012-209329.

(Formation of organic semiconductor layer)

A cartridge having a basic droplet rate of 10 pL was filled with the solution for organic semiconductor layer formation prepared above. Using an inkjet device (DMP-2831, manufactured by FUJIFILM Dimatix), the solution was printed onto the channel section between the source and drain electrodes that had been subjected to the above electrode modification. The solution was then dried on a hot plate at 90°C for 10 minutes to form an organic semiconductor layer, and thus an organic transistor was produced.

(Results of electrical characteristics)

For the produced organic transistor, a gate voltage (Vg) was scanned while setting a voltage (Vd) between the source and the drain to -15 V, and the transfer characteristic (Id-Vg) before bias voltage application was measured. As a result, mobility was 0.5 to 0.7 $cm^2$/V·s, and thus excellent mobility was exhibited.

<Evaluation of damage to organic semiconductor>

To the fluorine-based resin 1 obtained in Example 1, 4,4'-bis(diethylamino)benzophenone was added as a sensitizer, and a resultant mixture was dissolved in a 2,2,3,3,4,4,5,5-octafluoro-1-pentanol solvent to prepare a solution (fluorine-based resin: 15 wt%, sensitizer: 0.4 wt%). The solution was spin-coated onto the organic semiconductor layer of the organic transistor, and a protective film of approximately 2 μm was formed. After that, a mask having a light blocking section was brought into contact with the substrate on which the protective film had been formed, and irradiated with ultraviolet rays at 300 mJ/$cm^2$ for curing. Moreover, a fluorine-based solvent, 1,1,2,2-tetrafluoroethyl-2,2,2-trifluoroethylether, was used to remove the fluorine-based resin that was present on the light blocking section of the above mask to form a pattern. As a result, a change in mobility caused by the formation of the protective film was 5% or less, and there was no damage to the organic semiconductor.

Reference Signs List

1: Organic semiconductor layer
2: Substrate
3: Gate electrode
4: Gate insulating layer
5: Source electrode

6: Drain electrode
7: Pattern
8: Protective film layer

## Claims

**1.** A fluorine-based resin comprising:

a repeating unit that is represented by Formula (1) below including a photocrosslinkable group; and a repeating unit that includes a fluorine atom,

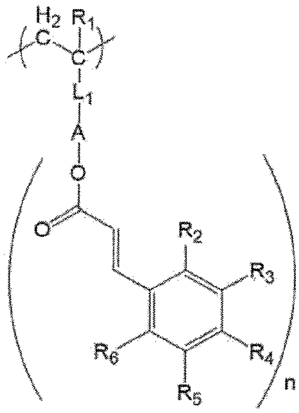

(1)

where $R_1$ represents a hydrogen atom or a methyl group, $L_1$ represents a single bond or a bivalent linking group, A represents a linking group having a valence of m, $R_2$, $R_3$, $R_4$, $R_5$, and $R_6$, which are identical to each other or different from each other, each represent one selected from the group consisting of a hydrogen atom, a halogen atom, linear alkyl groups having 1 to 20 carbon atoms, branched alkyl groups having 3 to 20 carbon atoms, cyclic alkyl groups having 3 to 20 carbon atoms, linear alkyl halide groups having 1 to 20 carbon atoms, alkoxy groups having 1 to 20 carbon atoms, aryl groups having 6 to 20 carbon atoms, aryloxy groups having 6 to 20 carbon atoms, a cyano group, and an amino group, m represents an integer of 3 or more, and n represents an integer of m-1.

**2.** The fluorine-based resin as set forth in claim 1, further comprising a repeating unit represented by Formula (2) below,

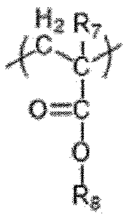

(2)

where $R_7$ represents a hydrogen atom or a methyl group, and $R_8$ represents an alkyl group having 1 to 30 carbon atoms.

**3.** The fluorine-based resin as set forth in claim 1 or 2, wherein:

the repeating unit including the above fluorine atom is a repeating unit represented by Formula (3) below,

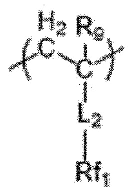

(3)

where $R_9$ represents a hydrogen atom or a methyl group, $L_2$ represents a single bond or a bivalent linking group, and $Rf_1$ represents one selected from the group consisting of linear fluoroalkyl groups having 1 to 15 carbon atoms, branched fluoroalkyl groups having 3 to 15 carbon atoms, and cyclic fluoroalkyl groups having 3 to 15 carbon atoms.

**4.** The fluorine-based resin as set forth in any one of claims 1 through 3, wherein:

in the above Formula (1), A is one linking group selected from the group consisting of Formulae (a-1) through (a-4) below,

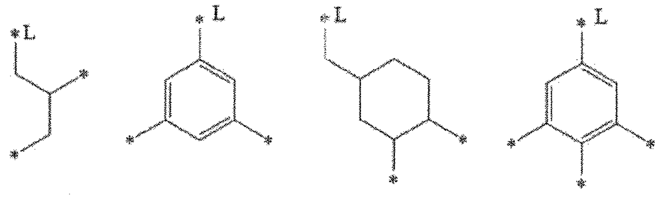

(a-1) (a-2) (a-3) (a-4)

in Formulae (a-1) through (a-4), *L represents a linkage position with $L_1$ in the above Formula (1), and * at an end of a carbon atom represents a linkage position with an oxygen atom constituting an ester group in the above Formula (1).

**5.** The fluorine-based resin as set forth in claim 4, wherein:
in the above Formula (1), A is a linking group represented by the above Formula (a-1).

**6.** The fluorine-based resin as set forth in any one of claims 1 through 5, which is soluble in a fluorine-based solvent.

**7.** A composition, comprising:

a fluorine-based resin recited in any one of claims 1 through 6; and
at least one of an organic solvent and a fluorine-based solvent.

**8.** A photocrosslinked product, which is obtained from a fluorine-based resin recited in any one of claims 1 through 6 or from a composition recited in claim 7.

**9.** A pattern, which is constituted by a photocrosslinked product recited in claim 8.

**10.** An electronic device, comprising a photocrosslinked product recited in claim 8.

**Patentansprüche**

**1.** Harz auf Fluorbasis, umfassend:

eine Repetiereinheit, die von der nachfolgenden Formel (1) dargestellt ist und eine lichtvernetzbare Gruppe umfasst; und
eine Repetiereinheit, die ein Fluoratom umfasst,

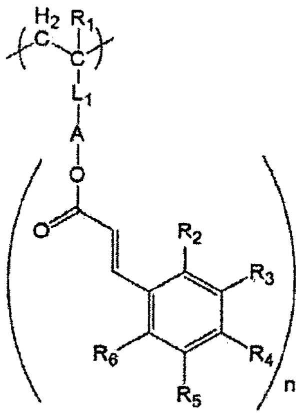

(1)

wo $R_1$ ein Wasserstoffatom oder eine Methylgruppe darstellt, $L_1$ eine Einfachbindung oder eine zweiwertige Verknüpfungsgruppe darstellt, A eine Verknüpfungsgruppe darstellt, die eine Wertigkeit von m aufweist, $R_2$, $R_3$, $R_4$, $R_5$ und $R_6$, die miteinander identisch sind oder sich voneinander unterscheiden, jeweils eines darstellen, das ausgewählt ist aus der Gruppe, die besteht aus einem Wasserstoffatom, einem Halogenatom, linearen Alkylgruppen, die 1 bis 20 Kohlenstoffatome aufweisen, verzweigten Alkylgruppen, die 3 bis 20 Kohlenstoffatome aufweisen, cyklischen Alkylgruppen, die 3 bis 20 Kohlenstoffatome aufweisen, linearen Alkylhalogenidgruppen, die 1 bis 20 Kohlenstoffatome aufweisen, Alkoxygruppen, die 1 bis 20 Kohlenstoffatome aufweisen, Arylgruppen, die 6 bis 20 Kohlenstoffatome aufweisen, Aryloxygruppen, die 6 bis 20 Kohlenstoffatome aufweisen, einer Cyano-Gruppe und einer Aminogruppe, wobei m eine ganze Zahl gleich 3 oder größer darstellt und n eine ganze Zahl gleich m-1 darstellt.

2. Harz auf Fluor-Basis nach Anspruch 1, ferner umfassend eine Repetiereinheit, die von der folgenden Formel (2) dargestellt ist,

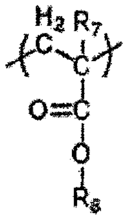

(2)

wo $R_7$ ein Wasserstoffatom oder eine Methylgruppe darstellt und $R_8$ eine Alkylgruppe darstellt, die 1 bis 30 Kohlenstoffatome aufweist.

3. Harz auf Fluor-Basis nach Anspruch 1 oder 2, wobei:

die Repetiereinheit, die das vorhergehende Fluoratom umfasst, eine Repetiereinheit ist, die von der folgenden Formel (3) dargestellt ist,

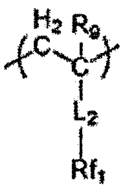

(3)

wo $R_9$ ein Wasserstoffatom oder eine Methylgruppe darstellt, $L_2$ eine Einfachbindung oder eine zweiwertige Verknüpfungsgruppe darstellt und $Rf_1$ eines darstellt, das ausgewählt ist aus der Gruppe, die besteht aus linearen Fluoralkylgruppen, die 1 bis 15 Kohlenstoffatome aufweisen, verzweigten Fluoralkylgruppen, die 3 bis 15 Kohlenstoffatome aufweisen, und cyclischen Fluoralkylgruppen, die 3 bis 15 Kohlenstoffatome aufweisen.

4. Harz auf Fluor-Basis nach einem der Ansprüche 1 bis 3, wobei:

in der vorhergehenden Formel (1) A eine Verknüpfungsgruppe ist, die ausgewählt ist aus der Gruppe, die aus den folgenden Formeln (a-1) bis (a-4) besteht,

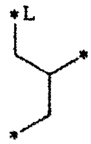
(a-1)

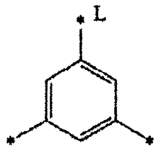
(a-2)

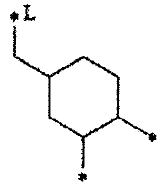
(a-3)

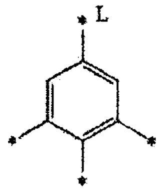
(a-4)

in den Formeln (a-1) bis (a-4) *L eine Verknüpfungsposition mit $L_1$ in der vorhergehenden Formel (1) darstellt und * am Ende eines Kohlenstoffatoms eine Verknüpfungsposition mit einem Sauerstoffatom darstellt, das eine Estergruppe in der vorhergehenden Formel (1) bildet.

**5.** Harz auf Fluor-Basis nach Anspruch 4, wobei:
in der vorhergehenden Formel (1) A eine Verknüpfungsgruppe ist, die von der vorhergehenden Formel (a-1) dargestellt ist.

**6.** Harz auf Fluor-Basis nach einem der Ansprüche 1 bis 5, das in einem Lösungsmittel auf Fluorbasis löslich ist.

**7.** Zusammensetzung, umfassend:

ein Harz auf Fluorbasis nach einem der Ansprüche 1 bis 6; und
mindestens eines von einem organischen Lösungsmittel und einem Lösungsmittel auf Fluorbasis.

**8.** Lichtvernetztes Produkt, das von einem Harz auf Fluorbasis nach einem der Ansprüche 1 bis 6 oder von einer Zusammensetzung nach Anspruch 7 erhalten wird.

**9.** Struktur, die aus einem lichtvernetzten Produkt nach Anspruch 8 gebildet ist.

**10.** Elektronische Vorrichtung, die ein lichtvernetztes Produkt nach Anspruch 8 umfasst.

## Revendications

**1.** Résine fluorée comprenant :

un motif répétitif qui est représenté par la formule (1) ci-dessous contenant un groupe photoréticulable ; et
un motif répétitif qui contient un atome de fluor,

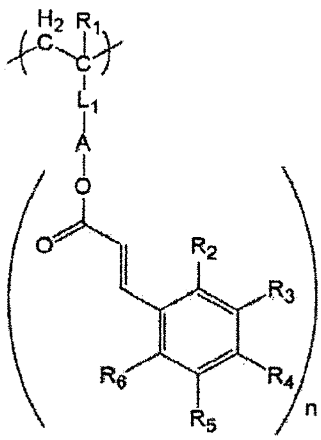
(1)

où $R_1$ représente un atome d'hydrogène ou un groupe méthyle, $L_1$ représente une liaison simple ou un groupe de

liaison divalent, A représente un groupe de liaison ayant une valence de m, chacun de $R_2$, $R_3$, $R_4$, $R_5$ et $R_6$, qui sont identiques ou différents, représente l'un choisi dans l'ensemble constitué par un atome d'hydrogène, un atome d'halogène, les groupes alkyle linéaires ayant 1 à 20 atomes de carbone, les groupes alkyle ramifiés ayant 3 à 20 atomes de carbone, les groupes alkyle cycliques ayant 3 à 20 atomes de carbone, les groupes halogénoalkyle linéaires ayant 1 à 20 atomes de carbone, les groupes alcoxy ayant 1 à 20 atomes de carbone, les groupes aryle ayant 6 à 20 atomes de carbone, les groupes aryloxy ayant 6 à 20 atomes de carbone, un groupe cyano, et un groupe amino, m représente un entier de 3 ou plus, et n représente un entier de m-1.

**2.** Résine fluorée selon la revendication 1, comprenant en outre un motif répétitif représenté par la formule (2) ci-dessous,

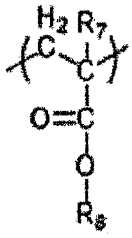 (2)

où $R_7$ représente un atome d'hydrogène ou un groupe méthyle, et $R_8$ représente un groupe alkyle ayant 1 à 30 atomes de carbone.

**3.** Résine fluorée selon la revendication 1 ou 2, dans laquelle :

le motif répétitif contenant l'atome de fluor ci-dessus est un motif répétitif représenté par la formule (3) ci-dessous,

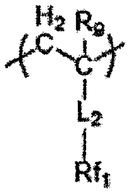 (3)

où $R_9$ représente un atome d'hydrogène ou un groupe méthyle, $L_2$ représente une liaison simple ou un groupe de liaison divalent, et $Rf_1$ représente l'un choisi dans l'ensemble constitué par les groupes fluoroalkyle linéaires ayant 1 à 15 atomes de carbone, les groupes fluoroalkyle ramifiés ayant 3 à 15 atomes de carbone, et les groupes fluoroalkyle cycliques ayant 3 à 15 atomes de carbone.

**4.** Résine fluorée selon l'une quelconque des revendications 1 à 3, dans laquelle :

dans la formule (1) ci-dessus, A est un groupe de liaison choisi dans l'ensemble constitué par les formules (a-1) à (a-4) ci-dessous,

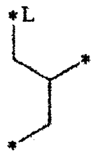
(a-1)

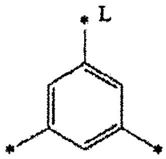
(a-2)

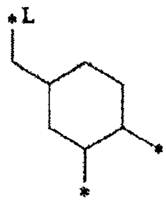
(a-3)

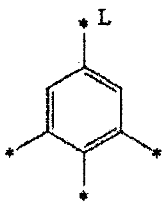
(a-4)

dans les formules (a-1) à (a-4), *L représente une position de liaison avec $L_1$ dans la formule (1) ci-dessus, et * à une extrémité d'un atome de carbone représente une position de liaison avec un atome d'oxygène constituant un groupe ester dans la formule (1) ci-dessus.

**5.** Résine fluorée selon la revendication 4, dans laquelle:
dans la formule (1) ci-dessus, A est un groupe de liaison représenté par la formule (a-1) ci-dessus.

**6.** Résine fluorée selon l'une quelconque des revendications 1 à 5, qui est soluble dans un solvant fluoré.

**7.** Composition comprenant :

une résine fluorée récitée dans l'une quelconque des revendications 1 à 6 ; et
au moins l'un parmi un solvant organique et un solvant fluoré.

**8.** Produit photoréticulé, qui est obtenu à partir d'une résine fluorée récitée dans l'une quelconque des revendications 1 à 6 ou à partir d'une composition récitée dans la revendication 7.

**9.** Motif qui est constitué par un produit photoréticulé récité dans la revendication 8.

**10.** Dispositif électronique comprenant un produit photoréticulé récité dans la revendication 8.

FIG. 1

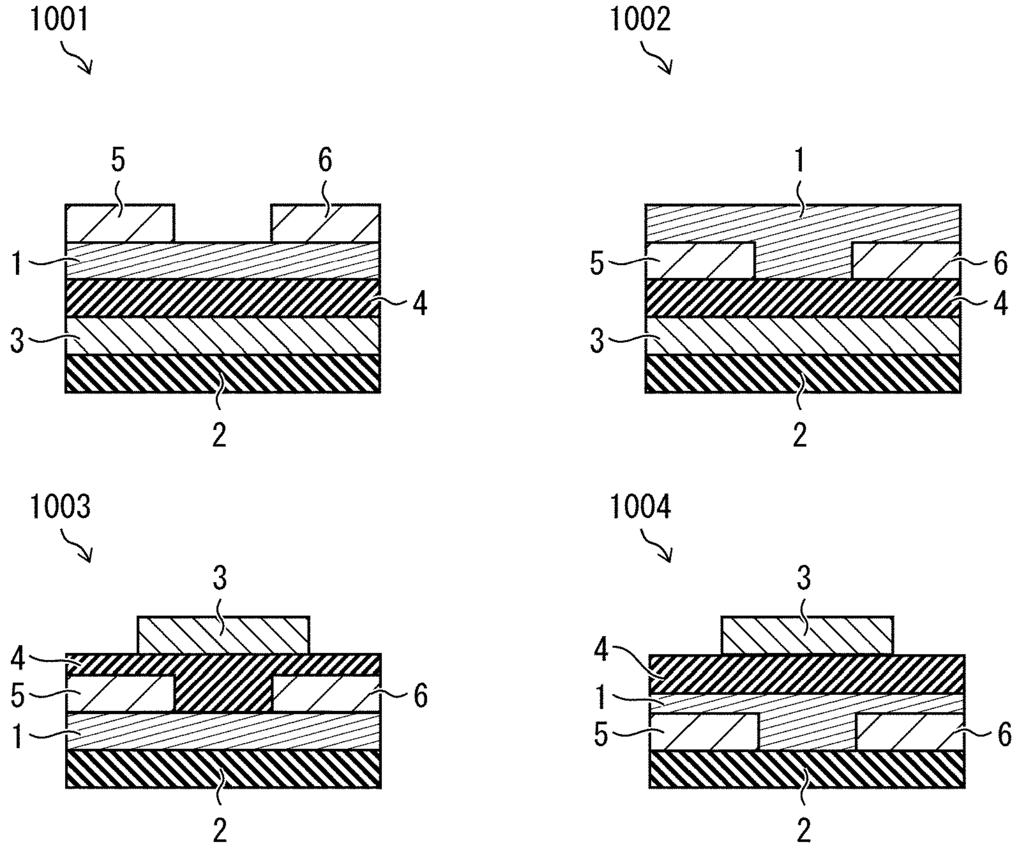
1001
5
6
1
4
3
2
1002
1
5
6
4
3
2
1003
3
4
5
6
1
2
1004
3
4
1
5
6
2

FIG. 2

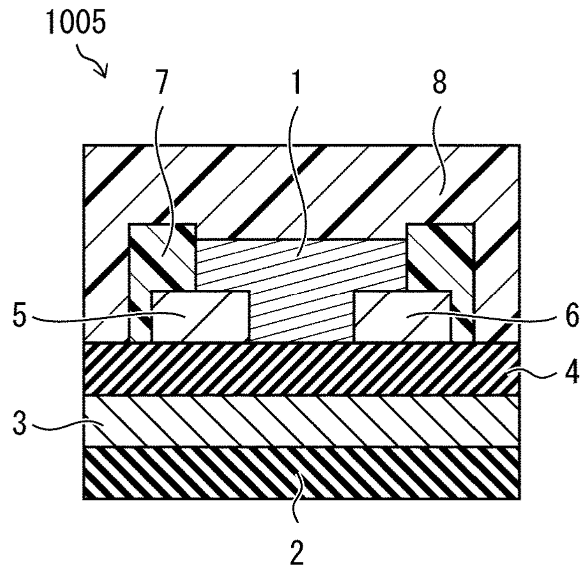
1005
7
1
8
5
6
4
3
2

FIG. 3

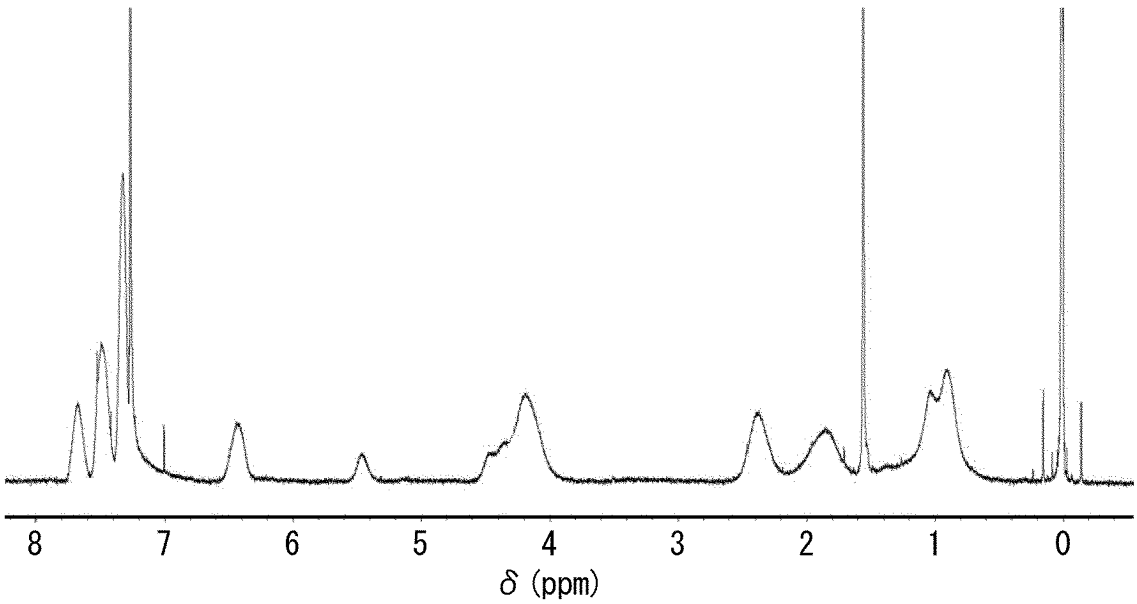

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*


### Patent documents cited in the description

- WO 2019003682 A1
- US 4529783 A1
- JP 2017167513 A
- JP 6281427 B
- JP 2015224238 A
- JP 2012209329 A

### Non-patent literature cited in the description

- *Appl. Phys. Express*, 2014, vol. 7, 101602
- *J Polym Sci A Polym Chem*, 2015, vol. 53, 1252